# EUROPEAN PATENT SPECIFICATION

(11) **EP 2 579 330 B1**
(45) Date of publication and mention of the grant of the patent: **11.10.2017**
(21) Application number: 11789384.2
(22) Date of filing: 27.04.2011
(51) Int. Cl.: H01L 31/049, B32B 27/32, B32B 27/36

(54) **SOLAR-CELL BACKSHEET AND SOLAR-CELL MODULE**
SOLARZELLEN-RÜCKSEITENFOLIE UND SOLARZELLENMODUL
FEUILLE ARRIÈRE DE CELLULE SOLAIRE ET MODULE DE CELLULE SOLAIRE

(30) Priority: 16.02.2011 JP 2011031301; 03.06.2010 JP 2010128211
(43) Date of publication of application: 10.04.2013
(73) Proprietor: KANEKA CORPORATION, Osaka (JP)
(72) Inventor: TANAKA, Katsuyuki, Osaka 566-0072 (JP); WADA, Kazuhito, Osaka 566-0072 (JP)
(74) Representative: Hoffmann Eitle
(86) International application number: PCT/JP2011/002471
(87) International publication number: WO 2011/151969

(56) References cited:
- WO-A1-2008/157159
- WO-A1-2010/002670
- JP-A- 2008 098 592
- JP-A- 2009 119 864

## Description

### Technical Field

The present invention relates to a back sheet for a solar battery, and a solar battery module containing the sheet.

### Background Art

In recent years, from the viewpoint of effective use of resources, the prevention of environmental pollution and others, attention to solar batteries, in which sunlight is directly converted to electric energy, has been increasing, and further researches thereabout have been advanced.

Solar batteries are classified into various forms, and typical examples thereof include amorphous silicon type solar batteries, crystal silicon type solar batteries, and dye-sensitization type solar batteries.

In general, silicon type solar batteries are each composed of a surface protecting member, a silicon power-generating element, a rear surface sealing member, a back sheet (rear surface protecting sheet).

Although amorphous silicon type solar batteries have an advantage that the use amount of silicon is small, the batteries are easily affected by humidity to have a problem of being lowered in power by the invasion of water vapor at a high humidity. In order to solve this problem, a back sheet excellent in humidity resistance (water-vapor-barrier performance) has been developed.

The back sheet is required to have not only a function of using humidity resistance to protect a silicon power-generating element, leading wires and other contents but also weather resistance, heat resistance, water resistance, an insulating property and corrosion resistance. Furthermore, the back sheet is required to have an adhesive property to an ethylene/vinyl acetate copolymer (EVA), which is ordinarily used for a rear surface sealing member.

As such a back sheet, known is, for example, a back sheet having a three-layer-structure of polyvinyl fluoride (PVF)/aluminum foil/PVF. Over long years, the back sheet has been used (Patent Document 1). This is a back sheet having a structure wherein a high water-vapor-barrier performance of the aluminum foil is used and further weather resistance and an insulating property are given by the PVF films. However, PVF has a problem of being poor in the adhesive property to EVA, which is used for a rear surface sealing member, and further has a problem of being expensive.

Suggested is also a back sheet having a laminated structure of a polyethylene terephthalate (PET) film, a resin film on which a metal oxide is vapor-deposited, and a PET film (Patent Document 2). However, in order to bond the vapor-deposit-attached resin film to the PET films, it is necessary to use an adhesive. Thus, a problem may be caused about the adhesive property between the films.

As a method for bonding individual constituting members of a laminate, known is generally a dry laminating method using an adhesive, such as a urethane adhesive. However, the dry laminating method has problems as described in the following: the adhesive used therein is hydrolyzed and deteriorated to be lowered in adhesive force; or a long period is required until the curing reaction of the adhesive is finished after the bonding between the members, so that production costs are increased. Thus, there remains room for improvement.

Suggested is also a back sheet using, as an adhesive layer, a maleic-anhydride-modified polyolefin resin (Patent Document 3). However, this modified polyolefin resin has a problem of being insufficient in the adhesive property to EVA or vapor-deposit-attached PET although the resin is excellent in the adhesive property to any polyolefin resin such as polypropylene.

### Prior Art Documents

### Patent Documents

- Patent Document 1:: JP-A-2008-235882
- Patent Document 2:: JP-A-2002-100788
- Patent Document 3:: JP-A-2008-270685

### DISCLOSURE OF THE INVENTION

### Problems to be Solved by the Invention

In light of the present situation, an object of the present invention is to provide a back sheet for a solar battery that is low in production costs, excellent in adhesive properties between individual constituting members thereof, and further excellent in weather resistance and water-vapor-barrier performance; and a solar battery module containing this sheet.

### Means for Solving the Problems

The inventors have found out that when a weather-resistant film and a different layer are laminated onto each other through a polyolefin resin subjected to specific modification, a back sheet for a solar battery can be provided which is excellent in both of the adhesive property and water-vapor-barrier performance while the sheet is low in production costs.

That is, the present invention relates to a back sheet for a solar battery, which comprises a laminate in which a first layer, a second layer and a third layer are laminated in this order, the first layer being arranged farthest from a solar battery element, wherein the first layer is a weather-resistant film selected from the group consisting of a weather-resistant polyester resin film and a fluororesin film, the second layer is a polyolefin layer which comprises a modified polyolefin resin yielded by grafting 1 to 30 parts by weight of an epoxy-group-containing vinyl monomer and 0.1 to 30 parts by weight of an aromatic vinyl monomer to 100 parts by weight of one or more polyolefin resins selected from the group consisting of polyethylene, polypropylene and an ethylene/propylene copolymer, and which has a thickness of 5 to 250 µm, the third layer is selected from the group consisting of a polyester-comprising layer, a polyolefin-comprising layer, and an aluminum foil piece, and the second layer and the third layer have a total thickness of 20 µm or more.

In the solar battery back sheet according to the present invention, it is preferred that the sheet further comprises a fourth layer laminated on a surface of the third layer that is a surface opposite to the second-layer-laminated surface of the third layer, the fourth layer is a polyolefin layer which comprises a modified polyolefin resin yielded by grafting 1 to 30 parts by weight of an epoxy-group-containing vinyl monomer to 100 parts by weight of one or more polyolefin resins selected from the group consisting of polyethylene, polypropylene and an ethylene/propylene copolymer, and which has a thickness of 5 to 250 µm, and the second layer, the third layer and the fourth layer have a total thickness of 100 µm or more.

Preferably, the second layer and the fourth layer have a total thickness larger than the thickness of the third layer.

Preferably, the third layer is a polyester film having, on one surface thereof, a vapor-deposited layer, the second layer and the fourth layer are different from each other in thickness, and the vapor-deposited layer is arranged to be opposed to a layer having a larger thickness out of the second layer and the fourth layer.

Preferably, the modified polyolefin resin of the fourth layer is a modified polyolefin resin yielded by further grafting 0.1 to 30 parts by weight of an aromatic vinyl monomer to 100 parts by weight of the polyolefin resin.

In the solar battery back sheet according to the present invention, it is preferred that the sheet further comprises a fifth layer laminated on a surface of the fourth layer that is a surface opposite to the third-layer-laminated surface of the fourth layer, and the fifth layer is a film selected from the group consisting of a polyester resin film and a fluororesin film.

Preferably, the third layer is a layer comprising a polyester, and the second layer is larger in thickness than the third layer.

Preferably, the adhesive strength between the first layer and the second layer, and that between the second layer and the third layer are each 2 N/cm or more, and the back sheet has a water vapor permeability (measuring conditions: 40°C and 90% RH) of 0.00001 to 3.0 g/(m²·day).

Preferably, the solar battery back sheet is formed by extrusion lamination of extruding a resin-comprising material constituting the second layer into a gap between the first layer and the third layer that is a layer in a film form.

Preferably, the solar battery back sheet is formed by extrusion lamination of extruding a resin-comprising material constituting the fourth layer into a gap between the third layer that is a layer in a film form and the fifth layer.

Preferably, the solar battery back sheet is formed by three-layer co-extrusion lamination of extruding each of a resin-comprising material constituting the second layer, a resin-comprising material constituting the third layer, and a resin-comprising material constituting the fourth layer on a surface of the first layer.

Preferably, the third layer is a polyester film having, on one surface, a vapor-deposited layer comprising an inorganic material or an inorganic oxide, and a polymeric film layer laminated on the vapor-deposited layer.

Preferably, the polymeric film layer comprises at least one resin selected from the group consisting of polyvinylidene chloride, polyvinyl alcohol, and an ethylene/vinyl alcohol copolymer.

Preferably, the first layer is a film comprising at least one selected from the group consisting of polyethylene terephthalate, polyethylene naphthalate, polyethylene fluoride, and polyethylene difluoride.

The present invention also relates to a solar battery module comprising a solar battery element, and the solar battery back sheet according to the present invention, wherein the first layer is arranged farthest from the solar battery element.

Furthermore, the invention relates to a solar battery module comprising a solar battery element, and the solar battery back sheet of the invention that comprises the first to the fourth layers, wherein the fourth layer contacts the solar battery element to seal the solar battery element.

### Effects of the Invention

The solar battery back sheet of the invention is excellent in weather resistance and water-vapor-barrier performance, and is further high in adhesive strength between individual constituting members thereof, and excellent in adhesion durability under hygrothermal conditions. Furthermore, the back sheet has an advantage of being low in production costs.

### MODE FOR CARRYING OUT THE INVENTION

The back sheet of the invention for a solar battery comprises a laminate in which at least a first layer, a second layer and a third layer are laminated in this order.

### (First Layer)

The first layer in the back sheet of the invention for a solar battery is a weather-resistant film selected from the group consisting of a weather-resistant polyester resin film and a fluororesin film. The first layer is arranged farthest from the solar battery. The solar battery back sheet is directly exposed to the outdoors. Thus, the back sheet is required to have weather resistance (including UV light resistance, humidity resistance, heat resistance, and salt damage resistance). The solar battery back sheet uses the weather-resistant film as the first layer, whereby the back sheet can have weather resistance.

Examples of the polyester resin constituting the weather-resistant polyester resin film include polyethylene terephthalate (PET), polybutylene terephthalate (PBT), and polyethylene naphthalate (PEN). The resin is preferably PET or PEN, more preferably PET. Examples of the fluororesin constituting the fluororesin film include polyethylene fluoride and polyethylene difluoride (polyvinylidene fluoride, PVDF). The resin is preferably PVDF.

The weather-resistant polyester resin film may be a film wherein an ultraviolet absorbent or some other is blended with a polyester resin to give weather resistance thereto; a film wherein a fluorine-containing paint is painted onto a surface of a polyester resin film to give weather resistance thereto; a vapor-deposit-attached polyester resin film wherein a vapor-deposited layer made of an inorganic material or an inorganic oxide is laminated on a surface of a polyester resin film; or a biaxially drawn polyester resin film.

Examples of the vapor-deposit-attached polyester resin film include films in each of which a vapor-deposited layer made of an inorganic material or an inorganic oxide is laminated on a polyester resin film as a substrate.

The vapor-deposited layer, which is made of an inorganic material or an inorganic oxide, may be a vapor-deposited layer made of aluminum oxide or silicon oxide. The vapor-deposited layer made of aluminum oxide appears to be made of a mixture of Al, AlO, Al₂O₃ and others. The ratio therebetween depends on conditions for the production. The vapor-deposited layer made of silicon oxide appears to be made of a mixture of Si, SiO, SiO₂ and others. The ratio therebetween depends on conditions for the production. Aluminum oxide and silicon oxide may be mixed with each other to be used. Such a mixed vapor-deposited layer is generally called a binary-vapor-deposited layer. A vapor-deposited layer made of SiN or SiON may also be used.

The thickness of the vapor-deposited layer made of an inorganic material or an inorganic oxide is preferably 1 to 500 nm, more preferably 5 to 300 nm from the viewpoint of the gas barrier performance and the flexibility thereof. For the formation of the vapor-deposited layer, use may be made of PVD methods (physical vapor deposition methods) such as vacuum deposition, sputtering and ion plating methods, CVD methods (chemical vapor deposition methods), and others.

The vapor-deposit-attached polyester resin film may be a film wherein a polymeric film layer, which may be referred to as a resin coat layer, is further laminated on the vapor-deposited layer, which is made of an organic material or an inorganic oxide. Examples of the polymer constituting the polymeric film layer include polyvinylidene chloride, polyvinyl alcohol, and an ethylene/vinyl alcohol copolymer. These may be used alone or in the form of a mixture. The lamination of the polymeric film layer makes it possible to coat pinholes and others in the vapor-deposited layer to attain a higher level of water-vapor-barrier performance.

A preferred embodiment of the vapor-deposit-attached polyester resin film is a vapor-deposit-attached PET film having a vapor-deposited layer comprising silica and/or alumina and having a water vapor permeability (measuring conditions: 40°C and 90% RH) of 0.00001 to 3.0 g/(m²·day). A more preferred embodiment thereof is a vapor-deposit-attached PET film having: a vapor-deposited layer comprising silica and/or alumina; and a polymeric film layer laminated on the vapor-deposited layer and comprising at least one selected from the group consisting of polyvinylidene chloride, polyvinyl alcohol and an ethylene/vinyl alcohol copolymer. Such a vapor-deposit-attached PET film is particularly good in water-vapor-barrier performance, bending property, and heat resistance.

The water vapor permeability of the vapor-deposit-attached polyester resin film is preferably 0.00001 to 3.0 g/(m²·day), more preferably 0.00001 to 1.0 g/(m²·day), even more preferably 0.00001 to 0.1 g/(m²·day) in order to prevent the invasion of water into the cells. The method for measuring the water vapor permeability may be a method described in JIS K 7128. If the water vapor permeability is high, water cannot be prevented from invading the solar battery element through the solar battery back sheet so that the element may be deteriorated.

The thickness of the vapor-deposit-attached polyester resin film is preferably 1 to 400 µm, more preferably 5 to 200 µm from the viewpoint of a balance between the water-vapor-barrier performance and the bending property. If the thickness is less than 1 µm, the back sheet may be insufficient in water-vapor-barrier performance. If the thickness is larger than 400 µm, the back sheet may be declined in bending property.

The vapor-deposit-attached polyester resin film may be a commercially available film. Examples thereof include silica-vapor-deposited PET (trade name: TECHBARRIER, manufactured by Mitsubishi Chemical Corp.), alumina-vapor-deposited PET (trade name: FINEBARRIER, manufactured by Reiko Co., Ltd.), binary-vapor-deposited PET (trade name: ECOSYAR VE500, manufactured by Toyobo Co., Ltd.), and silica-vapor-deposited PET coated with polyvinylidene chloride (trade name: KET VS-10, manufactured by Daicel Value Coating Ltd.).

### (Second Layer)

The second layer in the solar battery back sheet of the invention is sandwiched between the first layer and the third layer. The second layer is a layer shaped by extrusion lamination, which will be described later, in the production of the back sheet. This layer fulfills a function of bonding the first layer and the third layer to each other, and can further give predetermined water-vapor-barrier performance to the back sheet.

The second layer comprises a modified polyolefin resin yielded by grafting 1 to 30 parts by weight of an epoxy-group-containing vinyl monomer and 0.1 to 30 parts by weight of an aromatic vinyl monomer to 100 parts by weight of one or more polyolefin resins selected from the group consisting of polyethylene, polypropylene and an ethylene/propylene copolymer. This modified polyolefin resin has a layer structure wherein epoxy-group-containing graft chains form domains in the order of submicrons in a matrix of the polyolefin resin, whereby the layer can exhibit water-vapor-barrier performance. The layer comprising the modified polyolefin resin is excellent in the adhesive property to the first layer and the third layer. It is therefore unnecessary to use such an adhesive as used in conventional solar battery back sheets when the first layer and the third layer are bonded to each other.

### (Polyolefin Resin)

The polyolefin resin in the second layer is one or more polyolefin resins selected from the group consisting of polyethylene, polypropylene, and an ethylene/propylene copolymer (EPCP), and is preferably an ethylene/propylene copolymer.

Examples of the polyethylene include low-density polyethylene (LDPE), high-density polyethylene (HDPE), and linear low-density polyethylene (LLDPE). LDPE is preferred since this polyethylene can be produced on an industrial scale at low costs. LLDPE is a low-density polyethylene wherein short branched chains are introduced by copolymerizing ethylene with an α-olefin (such as propylene, butene, hexene, octene, or 4-methylpentene).

The polypropylene is preferably a soft polypropylene resin having a heat of fusion of 10 J/g or less (for example, Versify, manufactured by the Dow Chemical Co.). The soft polypropylene resin may be ethylene/propylene rubber (EPR) besides the ethylene/propylene copolymer (EPCP), which will be described later. This EPR denotes, for example, a mixture of polyethylene and polypropylene (such as PRIME TPO manufactured by Prime Polymer Co., Ltd. or Catalloy, which is a reactor TPO, manufactured by SunAllomer Ltd.), which is generally called a block type.

The ethylene/propylene copolymer (EPCP) is a random copolymer or a block copolymer made from ethylene, propylene, and one or more optionally added compounds selected from the group consisting of 1-butene, 1-hexene, and 1-octene. The copolymer is preferably a random copolymer made only from ethylene and propylene. In the invention, the copolymer is more preferably an ethylene/propylene copolymer having an ethylene content of 5 to 15% by weight from the viewpoint of keeping certainly softness necessary for the solar battery back sheet and necessary laminating-workability, and making appropriate the range of temperatures adapted for the adhesion or bonding, and the viewpoint of a matter that at the time of the melting and kneading for the production of the modified polyolefin resin, a denaturation reaction of the resin is sufficiently advanced.

### (Modified Polyolefin Resin)

The modified polyolefin resin in the second layer is a graft-modified product yielded by grafting an epoxy-group-containing vinyl monomer and an aromatic vinyl monomer to the polyolefin resin. This modified product can be produced by causing the epoxy-group-containing vinyl monomer and the aromatic vinyl monomer to react with the polyolefin resin in the presence of a radical polymerization initiator.

By the introduction of epoxy groups as functional groups into the polyolefin resin which constitutes the second layer, the adhesive property between the first layer and the third layer can be improved. Furthermore, the epoxy groups do not cause a decline in the water-vapor-barrier performance of the second layer, this situation being different from that of acidic groups such as carboxyl groups or acid anhydride groups. Moreover, the grafting of the aromatic vinyl monomer together with the epoxy-group-containing vinyl monomer makes it possible to heighten the graft rate of the epoxy-group-containing vinyl monomer (rate of the reaction of the epoxy-group-containing vinyl monomer with the polyolefin resin) to attain advantages based on the introduction of the epoxy groups certainly.

The reaction for the graft polymerization for attaining the grafting is not particularly limited, and may be, for example, solution polymerization, immersion polymerization or melt polymerization. Particularly preferred is melt polymerization since the polymerization is simple and easy. In the melt polymerization, it is advisable to melt and knead the polyolefin resin in the presence of a polymerization initiator and the individual monomers.

### (Epoxy-group-containing Vinyl Monomer)

The epoxy-group-containing vinyl monomer used in the invention is not particularly limited. Examples thereof include epoxyolefins such as glycidyl methacrylate, glycidyl acrylate, monoglycidyl maleate, diglycidyl maleate, monoglycidyl itaconate, diglycidyl itaconate, monoglycidyl allylsuccinate, diglycidyl allylsuccinate, glycidyl p-styrenecarboxylate, ally glycidyl ether, methallyl glycidyl ether, styrene-p-glycidyl ether, p-glycidylstyrene, 3,4-epoxy-1-butene, and 3,4-epoxy-3-methyl-1-butene; and vinylcyclohexene monooxide. These may be used alone or in combination of two or more thereof.

Of these examples, preferred are glycidyl methacrylate and glycidyl acrylate since the compounds are inexpensive. Particularly preferred is glycidyl methacrylate.

The addition amount of the epoxy-group-containing vinyl monomer is preferably 1 to 30 parts by weight, more preferably 1 to 15 parts by weight, even more preferably 1 to 10 parts by weight, in particular preferably 1 to 5 parts by weight to 100 parts by weight of the polyolefin resin. If the addition amount of the epoxy-group-containing vinyl monomer is too small, the adhesive property tends not to be sufficiently improved. If the addition amount is too large, a layer having a preferred shape or external appearance tends not to be formable.

### (Aromatic Vinyl Monomer)

The aromatic vinyl monomer used in the invention is not particularly limited. Examples thereof include styrene; methylstyrenes such as o-methylstyrene, m-methylstyrene, p-methylstyrene, α-methylstyrene, β-methylstyrene, dimethylstyrene, and trimethylstyrene; chlorostyrenes such as o-chlorostyrene, m-chlorostyrene, p-chlorostyrene, α-chlorostyrene, β-chlorostyrene, dichlorostyrene, and trichlorostyrene; bromostyrenes such as o-bromostyrene, m-bromostyrene, p-bromostyrene, dibromostyrene, and tribromostyrene; fluorostyrenes such as o-fluorostyrene, m-fluorostyrene, p-fluorostyrene, difluorostyrene, and trifluorostyrene; nitrostyrenes such as o-nitrostyrene, m-nitrostyrene, p-nitrostyrene, dinitrostyrene, and trinitrostyrene; vinylphenols such as o-hydroxystyrene, m-hydroxystyrene, p-hydroxystyrene, dihydroxystyrene, and trihydroxystyrene; divinylbenzenes such as o-divinylbenzene, m-divinylbenzene, and p-divinylbenzene; and diisopropenylbenzenes such as o-diisopropenylbenzene, m-diisopropenylbenzene, and p-diisopropenylbenzene. These may be used alone or in combination of two or more thereof.

Of these examples, preferred are styrene, methylstyrenes such as α-methylstyrene and p-methylstyrene, and a monomer of the divinylbenzenes or a mixture of isomers thereof since these are inexpensive. Styrene is particularly preferred.

The addition amount of the aromatic vinyl monomer is preferably 0.1 to 30 parts by weight, more preferably 1 to 30 parts by weight, even more preferably 1 to 15 parts by weight, in particular preferably 3 to 5 parts by weight to 100 parts by weight of the polyolefin resin. If the addition amount of the aromatic vinyl monomer is too small, the graft rate of the epoxy-group-containing vinyl monomer to the polyolefin resin tends to be poor. If the addition amount is too large, the graft rate tends to come into the range of the saturation so that uneconomical results are caused.

### (Radical Polymerization Initiator)

In the graft-copolymerization of the epoxy-group-containing vinyl monomer and the aromatic vinyl monomer to the polyolefin resin, a radical polymerization initiator is used to start a reaction for the polymerization.

The radical polymerization initiator used in the invention may be, for example, a peroxide or an azo compound.

Specific examples thereof include ketone peroxides such as methyl ethyl ketone peroxide and methyl acetoacetate peroxide; peroxyketals such as 1,1-bis(t-butylperoxy)-3,3,5-trimethylcyclohexane, 1,1-bis(t-butylperoxy)cyclohexane, n-butyl-4,4-bis(t-butylperoxy)valerate, and 2,2-bis(t-butylperoxy)butane; hydroperoxides such as permethane hydroperoxide, 1,1,3,3-tetramethylbutylhydroperoxide, diisopropylbenzene hydroperoxide, and cumene hydroperoxide; dialkylperoxides such as dicumylperoxide, 2,5-dimethyl-2,5-di(t-butylperoxy)hexane, α,α'-bis(t-butylperoxy-m-isopropyl)benzene, t-butylcumylperoxide, di-t-butylperoxide, and 2,5-dimethyl-2,5-di(t-butylperoxy)hexyne-3; diacylperoxides such as benzoylperoxide; peroxydicarbonates such as di(3-methyl-3-methoxybutyl)peroxydicarbonate and di-2-methoxybutylperoxydicarbonate; and peroxyesters such as t-butyl peroxyoctate, t-butyl peroxyisobutyrate, t-butyl peroxylaurate, t-butyl peroxy-3,5,5-trimethylhexanoate, t-butyl peroxyisopropylcarbonate, 2,5-dimethyl-2,5-di(benzoylperoxy)hexane, t-butyl peroxyacetate, t-butyl peroxybenzoate, and di-t-butyl peroxyisophthate.

It is preferred to use, out of these examples, a peroxyketal such as 1,1-bis(t-butylperoxy)-3,3,5-trimethylcyclohexane, 1,1-bis(t-butylperoxy)cyclohexane, n-butyl-4,4-bis(t-butylperoxy)valerate, or 2,2-bis(t-butylperoxy)butane; a dialkylperoxide such as dicumylperoxide, 2,5-dimethyl-2,5-di(t-butylperoxy)hexane, α,α'-bis(t-butylperoxy-m-isopropyl)benzene, t-butylcumylperoxide, di-t-butylperoxide, or 2,5-dimethyl-2,5-di(t-butylperoxy)hexyne-3; a diacylperoxide such as benzoylperoxide; or t-butyl peroxyoctate, t-butyl peroxyisobutyrate, t-butyl peroxylaurate, t-butyl peroxy-3,5,5-trimethylhexanoate, t-butyl peroxyisopropylcarbonate, 2,5-dimethyl-2,5-di(benzoylperoxy)hexane, t-butyl peroxyacetate, t-butyl peroxybenzoate, or di-t-butyl peroxyisophthate since these exhibit high hydrogen abstraction capability. These radical polymerization initiators may be used alone or in combination of two or more thereof.

The addition amount of the radical polymerization initiator is preferably 0.01 to 10 parts by weight, more preferably 0.2 to 5 parts by weight to 100 parts by weight of the polyolefin resin in order to advance the modifying reaction sufficiently, and keep the fluidity and mechanical properties of the resultant modified product certainly.

### (Additives)

Additive(s) may be added to the modified polyolefin resin which constitutes the second layer, examples of the additive(s) including a thermoplastic resin, an elastomer, a tackiness supplier (tackifier), a plasticizer, an antioxidant, a metal inactivating agent, a phosphorus-based process stabilizer, an ultraviolet absorbent, an ultraviolet stabilizer, a fluorescent whitening agent, a metal soap, an acid-controlling adsorbent, a radical scavenger, a water scavenger, other stabilizers, a crosslinking agent, a chain transfer agent, a nucleating agent, a lubricant, a filler, a reinforcing agent, a pigment, a dye, a flame retardant, and an antistatic agent. The additives are preferably a tackiness supplier (tackifier) and a plasticizer, in particular preferably a tackiness supplier.

Examples of the thermoplastic resin include an acrylonitrile/butadiene/styrene copolymer, a hydrogenated product thereof, polystyrene, polyvinyl chloride, polymethyl methacrylate, polyurethane, a polyester and polylactic acid.

Examples of the elastomer include a styrene-based thermoplastic elastomer (TPS), an olefin-based thermoplastic elastomer (TPO), butyl rubber, acrylic rubber, butadiene rubber, isoprene rubber, and styrene/butadiene rubber.

Examples of the plasticizer include petroleum process oils such as paraffin-based process oil, naphthene-based process oil and aromatic process oil, silicone oil, liquid polybutene, liquid polyisoprene, and other lower-molecular-weight liquid polymers.

Examples of the radical scavenger include phenol-based scavengers, phosphorus-based scavengers, sulfur-based scavengers, and HALS-based scavengers. It is preferred to incorporate the radical scavenger into the resin constituting the second layer in a proportion of 0 to 3% by mass.

Examples of the water scavenger include oxides, sulfates and silicates of any alkaline earth metal. The water scavenger is preferably zeolite. It is preferred to incorporate the water scavenger into the resin constituting the second layer in a proportion of 0 to 20% by mass.

The tackifier resin, that is, the tackifier is not particularly limited. Examples thereof include rosin resins (such as gum rosin, tall oil rosin, wood rosin, hydrogenated rosin, disproportionated rosin, polymerized rosin, maleated rosin, rosin/glycerin ester, and hydrogenated rosin/glycerin ester), a terpene phenolic resin, hydrogenated products thereof, terpene resins (such as resins each made mainly of α-pinene, β-pinene, or dipentene), a hydrogenated product thereof, aromatic-hydrocarbon-modified terpene resins, petroleum resins (such as aliphatic, alicyclic and aromatic resins), a coumarone-indene resin, styrene resins (such as styrene-based and substituted-styrene-based resins), phenolic resins (such as alkylphenolic resin and rosin-modified phenolic resin), and xylene resins. These may be used alone or in combination of two or more thereof.

The tackifier resin is preferably a low-molecular-weight resin having a number average molecular weight of 300 to 3000, and a softening point of 20 to 200°C, more preferably 60 to 150°C, the softening point being according to a ring and ball method prescribed in JIS K-2207.

The tackifier resin used in the invention is preferably a terpene resin, and is more preferably one or more selected from the group consisting of terpene phenolic resins, hydrogenated terpene resins, and hydrogenated terpene phenolic resins since these resins are good in compatibility and heat resistance. More preferred are hydrogenated terpene phenolic resins in order that the second layer can keep transparency certainly.

Of the terpene phenolic resins, particularly preferred is a terpene phenolic resin having a softening point in the range of 20 to 200°C and a number average molecular weight in the range of 300 to 1200 for compatibility, and an improvement in the adhesive force.

Specific examples of the hydrogenated terpene resins include KURIARON P type resin manufactured by Yasuhara Chemical Co., Ltd. (hydrogenated dipentene resin of a nonpolar type: KURIARON P-105), and K type resin manufactured by Yasuhara Chemical Co., Ltd. (hydrogenated aromatic modified terpene resin of a polar type: KURIARON K-4100).

Specific examples of the hydrogenated terpene phenolic resins include YS POLYSTAR TH130 and UH115 manufactured by Yasuhara Chemical Co., Ltd.

The blend amount of the tackifier resin usable in the invention is not particularly limited. The amount is preferably 0.1 to 50 parts by weight, more preferably 0.1 to 30 parts by weight, even more preferably 0.3 to 20 parts by weight, in particular preferably 0.5 to 10 parts by weight to 100 parts by weight of the modified polyolefin resin.

The above-mentioned additives may each be added beforehand to the polyolefin resin as a raw material, added thereto when the polyolefin resin are melted and kneaded to modify the resin, or added after the modified polyolefin resin is produced.

It is preferred that a composition which contains the modified polyolefin resin, which constitutes the second layer, does not contain any silane coupling agent. A silane coupling agent may undergo a change with time not to keep reliability easily, thereby making the back sheet of the invention low in yield. When no silane coupling agent is used, an improvement can be made in the reliability of a solar battery module wherein the solar battery back sheet of the invention is used. Moreover, the back sheet can be produced with a high yield.

### (Melting and Kneading)

Examples of a melting and kneading machine used to produce the modified polyolefin resin include an extruder, a Banbury mixer, a mill, a kneader, and a heating roll. It is preferred from the viewpoint of production performance to use a monoaxial or biaxial extruder. In order to mix the individual materials sufficiently into an even state, melting and kneading may be repeated plural times.

In the melting and kneading, the order of the addition of the individual components, and the method therefor are not particularly limited. It is preferred to add the epoxy-group-containing vinyl monomer and the aromatic vinyl monomer to a mixture wherein the polyolefin resin and the radical polymerization initiator are melted and kneaded, and then melt and knead the resultant mixture. This manner makes it possible to restrain the generation of low-molecular-weight compounds which do not contribute to any graft, so as to improve the graft rate. The order of the addition of optionally added materials, and the method therefor are not particularly limited, either. In the melting and kneading, the heating temperature is preferably 100 to 300°C to melt the polyolefin resin sufficiently and cause the resin not to be thermally decomposed. The temperature is more preferably 130 to 250°C. The period for the melting and kneading (period from the incorporation of the radical polymerization initiator) is usually 30 seconds to 60 minutes.

In the invention, the thickness of the second layer, which contains the modified polyolefin resin, is 5 to 250 µm. If the thickness of the second layer is smaller than 5 µm, a sufficient adhesive property and water-vapor-barrier performance based on the second layer cannot be realized. Reversely, if the thickness is more than 250 µm, in a process for producing a solar battery module, a period necessary for vacuum laminating becomes long. Thus, the second layer is not substantially usable for any solar battery back sheet. The thickness is more preferably 10 to 250 µm.

In the invention, the adhesive strength between the first layer and the second layer is preferably 2 N/cm or more. This case makes it possible to realize an interlaminar adhesive property necessary for the solar battery back sheet without using any different adhesive. This adhesive strength can be attained by extrusion lamination which will be described later.

### (Third Layer)

The third layer is laminated on the second layer. When the back sheet is in the form of including a fourth layer, the third layer is sandwiched between the second layer and the fourth layer. The second layer is selected from the group consisting of a polyester-comprising layer, a polyolefin-comprising layer, and an aluminum foil piece. When the third layer is a polyester-comprising layer or a polyolefin-comprising layer, the third layer may be formed by the extrusion lamination, which will be described later, in the production of the back sheet, or may be a resin film shaped in advance.

The third layer is a layer chiefly for taking charge of water-vapor-barrier performance. However, the performance of the layer is not limited to this performance. The aluminum foil piece, out of these laminar members, may be unfavorably corroded when used over a long term. Moreover, the other resin layers need to be made thick to keep voltage resistance certainly for the back sheet. It is therefore preferred that the third layer is the polyester-comprising layer or polyolefin-comprising layer.

The second and third layers are formed to have a total thickness of 20 µm or more. This manner makes it possible to keep certainly voltage resistance necessary for the solar battery back sheet. The thickness is preferably 30 µm or more and 300 µm or less.

The polyester-comprising layer, which is a form of the third layer, is preferably a weather-resistant polyester resin film. This weather-resistant polyester resin film may be any one of the films described about the first layer.

Examples of the polyester resin constituting the weather-resistant polyester resin film include polyethylene terephthalate (PET), polybutylene terephthalate (PBT), and polyethylene naphthalate (PEN). The polyethylene resin is preferably PET or PEN, more preferably PET. Examples of the fluororesin constituting the fluororesin film include polyethylene fluoride and polyethylene difluoride (polyvinylidene fluoride, PVDF). The resin is preferably PVDF.

The weather-resistant polyester resin film may be a film wherein an ultraviolet absorbent or some other is blended with a polyester resin to give weather resistance thereto; a vapor-deposit-attached polyester resin film wherein a vapor-deposited layer made of an inorganic material or an inorganic oxide is laminated on a surface of a polyester resin film (a polyester resin film having, on one surface thereof, a vapor-deposited layer); or a biaxially drawn polyester resin film.

Examples of the vapor-deposit-attached polyester resin film include films in each of which a vapor-deposited layer made of an inorganic material or an inorganic oxide is laminated on a polyester resin film as a substrate.

The vapor-deposited layer, which is made of an inorganic material or an inorganic oxide, may be a vapor-deposited layer made of aluminum oxide or silicon oxide. The vapor-deposited layer made of aluminum oxide appears to be made of a mixture of Al, AlO, Al₂O₃ and others. The ratio therebetween depends on conditions for the production. The vapor-deposited layer made of silicon oxide appears to be made of a mixture of Si, SiO, SiO₂ and others. The ratio therebetween depends on conditions for the production. Aluminum oxide and silicon oxide may be mixed with each other to be used. Such a mixed vapor-deposited layer is generally called a binary-vapor-deposited layer. A vapor-deposited layer made of SiN or SiON may be used.

The thickness of the vapor-deposited layer, which is made of an inorganic material or an inorganic oxide, is preferably 1 to 500 nm, more preferably 5 to 300 nm from the viewpoint of gas barrier performance and flexibility. For the formation of the vapor-deposited layer, use may be made of PVD methods (physical vapor deposition methods) such as vacuum deposition, sputtering, and ion plating methods, CVD methods (chemical vapor deposition methods), and others.

The vapor-deposit-attached polyester resin film may be a film wherein a polymeric film layer, which may be referred to as a resin coat layer, is further laminated on the vapor-deposited layer, which is made of an organic material or an inorganic oxide. Examples of the polymer constituting the polymeric film layer include polyvinylidene chloride, polyvinyl alcohol, and an ethylene/vinyl alcohol copolymer. These may be used alone or in the form of a mixture. The lamination of the polymeric film layer makes it possible to coat pinholes and others in the vapor-deposited layer to attain a higher level of water-vapor-barrier performance.

A preferred embodiment of the vapor-deposit-attached polyester resin film is a vapor-deposit-attached PET film having a vapor-deposited layer comprising silica and/or alumina and having a water vapor permeability (measuring conditions: 40°C and 90% RH) of 0.00001 to 3.0 g/(m²·day). A more preferred embodiment thereof is a vapor-deposit-attached PET film having: a vapor-deposited layer comprising silica and/or alumina; and a polymeric film layer laminated on the vapor-deposited layer and comprising at least one selected from the group consisting of polyvinylidene chloride, polyvinyl alcohol and an ethylene/vinyl alcohol copolymer. Such a vapor-deposit-attached PET film is particularly good in water-vapor-barrier performance, bending property, and heat resistance.

The water vapor permeability (measuring conditions: 40°C and 90% RH) of the vapor-deposit-attached polyester resin film is preferably 0.00001 to 3.0 g/(m²·day), more preferably 0.00001 to 1.0 g/(m²·day), even more preferably 0.00001 to 0.1 g/(m²·day) in order to prevent the invasion of water into the cells. The method for measuring the water vapor permeability may be a method described in JIS K 7128. If the water vapor permeability is high, water cannot be prevented from invading the solar battery element through the solar battery back sheet so that the element may be deteriorated.

The thickness of the vapor-deposit-attached polyester resin film is preferably 1 to 400 µm, more preferably 5 to 200 µm from the viewpoint of a balance between the water-vapor-barrier performance and the bending property. If the thickness is less than 1 µm, the back sheet may be insufficient in water-vapor-barrier performance. If the thickness is larger than 400 µm, the back sheet may be declined in bending property.

The vapor-deposit-attached polyester resin film may be a commercially available film. Examples thereof include silica-vapor-deposited PET (trade name: TECHBARRIER, manufactured by Mitsubishi Chemical Corp.), alumina-vapor-deposited PET (trade name: FINEBARRIER, manufactured by Reiko Co., Ltd.), binary-vapor-deposited PET (trade name: ECOSYAR VE500, manufactured by Toyobo Co., Ltd.), and silica-vapor-deposited PET coated with polyvinylidene chloride (trade name: KET VS-10, manufactured by Daicel Value Coating Ltd.).

The polyolefin-comprising film, which is another form of the third layer, may be identical with the polyolefin-resin-comprising layer described about the second layer. This polyolefin resin layer may be a layer comprising a modified polyolefin resin in the same manner as in the second layer, and is preferably a layer comprising a polyethylene resin not modified. This layer needs no modifying step to be advantageous from the viewpoint of costs.

The polyolefin resin is one or more polyolefin resins selected from the group consisting of polyethylene, polypropylene and an ethylene/propylene copolymer (EPCP), and is preferably an ethylene/propylene copolymer.

Examples of the polyethylene include low-density polyethylene (LDPE), high-density polyethylene (HDPE), and linear low-density polyethylene (LLDPE). LDPE is preferred since this polyethylene can be produced on an industrial scale at low costs. LLDPE is a low-density polyethylene wherein short branched chains are introduced by copolymerizing ethylene with an α-olefin (such as propylene, butene, hexene, octene, or 4-methylpentene).

The polypropylene is preferably a soft polypropylene resin having a heat of fusion of 10 J/g or less (for example, Versify, manufactured by the Dow Chemical Co.). The soft polypropylene resin may be ethylene/propylene rubber (EPR) besides the ethylene/propylene copolymer (EPCP), which will be described later. This EPR denotes, for example, a mixture of polyethylene and polypropylene (such as PRIME TPO manufactured by Prime Polymer Co., Ltd. or Catalloy, which is a reactor TPO, manufactured by SunAllomer Ltd.), which is generally called a block type.

The ethylene/propylene copolymer (EPCP) is a random copolymer or a block copolymer made from ethylene, propylene, and one or more optionally added compounds selected from the group consisting of 1-butene, 1-hexene, and 1-octene. The copolymer is preferably a random copolymer made only from ethylene and propylene. In the invention, the copolymer is more preferably an ethylene/propylene copolymer having an ethylene content of 5 to 15% by weight from the viewpoint of keeping certainly softness necessary for the solar battery back sheet and necessary laminating-workability, and making appropriate the range of temperatures adapted for the adhesion or bonding.

The thickness of the polyolefin-comprising layer, which is the third layer, is preferably 30 to 600 µm. If the thickness is smaller than 30 µm, the back sheet may be insufficient in water-vapor-barrier performance. If the thickness is more than 600 µm, the back sheet may be declined in bending property.

The aluminum foil piece, which is still another embodiment of the third layer, may be an ordinary soft aluminum foil piece. In order to make the back sheet high in pinhole resistance, the aluminum foil piece may be an aluminum foil piece having an iron content of 0.1 to 9.0% by mass, preferably 0.5 to 2.0% by mass. If the iron content is less than 0.1% by mass, pinhole resistance is not sufficiently given thereto. If the content is more than 9.0% by mass, the back sheet may be damaged in flexibility. The thickness of the aluminum foil piece is preferably 5 to 200 µm, more preferably 15 to 100 µm, considering the water-vapor-barrier performance, pinhole resistance and workability thereof.

In the invention, the adhesive strength between the second layer and the third layer is preferably 2 N/cm or more. This case can realize an interlaminar adhesive property necessary for the solar battery back sheet without using any different adhesive. This adhesive strength can be attained by the extrusion lamination, which will be described later.

### (Fourth Layer)

The solar battery back sheet of the invention may be a sheet made only of the first, second and third layers, or may be a sheet including, besides these layers, a fourth layer. In this case, the fourth layer is laminated on a surface of the third layer that is a surface opposite to the second-layer-laminated surface of the third layer. Thus, the first, second, third and fourth layers are laminated in this order. The fourth layer is a layer formed by the extrusion lamination, which will be described later, in the production of the back sheet. When a fifth layer which will be described later is to be laid, the fourth layer is laid to heighten the adhesive property between the third layer and the fifth layer. When the fifth layer is not to be laid, the fourth layer can also fulfill a function of sealing a solar battery element by arranging the solar battery element to contact the front surface of the fourth layer directly.

The fourth layer comprises a modified polyolefin resin yielded by grafting an epoxy-group-containing vinyl monomer to one or more polyolefin resins selected from the group consisting of polyethylene, polypropylene and an ethylene/propylene copolymer, and has a thickness of 5 to 250 µm. The material constituting the modified polyolefin resin of the fourth layer may be the same as used for the modified polyolefin resin of the second layer. Thus, the description thereof is omitted.

However, in the fourth layer, modification with an aromatic vinyl monomer is not essential. Accordingly, the blend amount of an aromatic vinyl monomer is 0 to 30 parts by weight to 100 parts by weight of the polyolefin resin. However, when the fourth layer contains the aromatic vinyl monomer, the blend amount thereof is preferably 0.1 to 30 parts by weight. When the polyolefin resin of the fourth layer is modified with the aromatic vinyl monomer, the main chain of this resin can be prevented from being fractured in the melting and kneading. When co-extrusion is used in the production of the sheet, the respective resin viscosities of the second to fourth layers can each be controlled into a predetermined range so that the range of conditions for performing the co-extrusion can be expanded. In the fourth layer, the content of the aromatic vinyl monomer is preferably 0.1 to 5 parts by weight, more preferably 2 to 5 parts by weight.

In the invention, the thickness of the fourth layer is 5 to 250 µm, preferably 5 to 100 µm. If the thickness is less than 5 µm, the back sheet is not easily made into a sufficient level about the adhesive property between the third layer and the fifth layer, or about the performance of sealing a solar battery element. If the thickness is more than 250 µm, the back sheet may be declined in bending property.

In the invention, the total thickness of the second, third and fourth layers is preferably 100 µm or more to permit the back sheet to keep a sufficient adhesive property and voltage resistance certainly. The thickness is more preferably 300 µm or more, even more preferably 400 µm or more. The upper limit of the total thickness is preferably 700 µm or less to permit the back sheet to keep bending property certainly.

The total thickness of the second layer and the fourth layer is preferably larger than the thickness of the third layer. In this case, a sufficient interlaminar adhesive property can be certainly kept without using any different adhesive.

When the third layer is a polyester film having one surface with a vapor-deposited layer, the vapor-deposited layer is preferably arranged to be opposed to a layer having a larger thickness out of the second layer and the fourth layer. When the respective resin materials constituting the second and fourth layers are successively extruded onto surfaces of the film-form third layer, respectively, at two stages to laminate the three layers onto each other, the vapor-deposited layer of the third layer is covered at the time of the extrusion at the first stage, whereby the vapor-deposited layer can be protected in the step of the extrusion at the second stage. Furthermore, as the thickness of each of the second and fourth layers is larger, the solar battery back sheet is less easily curled. Thus, by making thicker a layer formed by the extrusion at the first stage out of the second layer and the fourth layer, the curling can be restrained with higher certainty. Between cases where the thickness of each of the second and fourth layers is set to, for example, 90 µm, and where the thickness of the layer formed by the extrusion at the first stage, out of the second layer and the fourth layer, is set to 135 µm, and that of the layer formed by the extrusion at the second stage is set to 45 µm, no change is made in the total thickness of the second and fourth layers. However, the inventors have found out that in the latter case, the curling can be restrained with higher certainty. From this matter, it is preferred to arrange the vapor-deposited layer of the third layer to be opposed to a thicker layer out of the second layer and the fourth layer.

### (Fifth Layer)

The solar battery back sheet of the invention may further comprise, besides the first to fourth layers, a fifth layer on a surface of the fourth layer that is a surface opposite to the third-layer-laminated surface of the fourth layer. At this time, the first, second, third, fourth and fifth layers are laminated in this order.

The fifth layer may be made of a film selected from the group consisting of a polyester resin film and a fluororesin film. The polyester resin film which constitutes the fifth layer may be the weather-resistant polyester resin film as used for the first layer, or may be an ordinary polyester resin film. When the fifth layer is a weather-resistant film, the laying of the fifth layer results in a matter that both surfaces of the solar battery back sheet are made of the weather-resistant layers, respectively, so that the whole of the back sheet can be made higher in weather resistance.

The fifth layer is arranged at a position near a solar battery. It is therefore preferred that the fifth layer is formed to reflect sunlight in such a manner that the solar battery can make the most of the sunlight. From this viewpoint, it is preferred to incorporate a white pigment into the weather-resistant film.

In the case of using a film shaped in advance as any one of the layers constituting the solar battery back sheet of the invention, a surface of the film may be subjected to a treatment for giving an adhesive property thereto, such as corona treatment, plasma treatment, or primer-coat application.

### (Physical Properties)

The solar battery back sheet of the invention preferably exhibits a water vapor permeability (measuring conditions: 40°C and 90% RH) of 0.00001 to 3.0 g/(m²·day) in order to attain a high level of water-vapor-barrier performance. The water vapor permeability is more preferably 0.00001 to 1.0 g/(m²·day), even more preferably 0.00001 to 0.1 g/(m²·day). The method used for measuring the water vapor permeability is a method described in JIS K 7128.

### (Producing Method, Method A)

The following will describe a method for producing the solar battery back sheet of the invention. However, the solar battery back sheet of the invention is not limited by the producing method described below.

First, a description is made about a method for producing a solar battery back sheet of the invention, using a shaped film as its third layer (hereinafter, the method will be referred to as the method A).

In addition to the matter that its first layer is a film in the method A, the third layer is also the shaped film (resin film or aluminum foil piece), and the solar battery back sheet is formed by extrusion lamination of extruding a resin-comprising material constituting its second layer into a gap between the first layer and the third layer.

First, the resin-comprising material which constitutes the second layer is supplied to an extruder, and then heated and melted therein.

Before the supply of the resin-comprising material to the extruder, it is preferred to dry the resin-comprising material preliminarily in advance. The preliminary drying makes it possible to prevent the material extruded out from the extruder from being foamed. The method for the preliminary drying is not particularly limited. The drying may be attained by use of, for example, a hot wind drying machine in the state of making the resin-comprising material into the form of pellets or some other.

Next, the resin-comprising material heated and melted in the extruder is supplied to a T-die. At this time, the use of a gear pump makes it possible to improve the evenness of the extruded quantity of the material to decrease unevenness in the thickness of the layer to be formed.

Next, the resin-comprising material supplied to the T-die is extruded as a melted resin in a sheet form from the T-die. Two laminating rolls are used to sandwich the sheet-form melted resin between the first layer and the third layer to laminate the three layers onto each other. In this way, the first layer and the third layer are bonded to each other through the second layer to yield a sheet having a three-layered structure.

Preferably, one of the two laminating rolls, between which the sheet-form melted resin is sandwiched, is a rigid metal roll having a smooth surface, and the other is a flexible roll having an elastic outer cylinder which has a smooth surface and is elastically deformable. Between the rigid metal roll and the flexible roll having the elastic outer cylinder, the sheet-form melted resin is sandwiched, and the layers are laminated onto each other. In this way, a sheet can be yielded which is good in the adhesive property between its individual layers and in surface external appearance.

The surface temperature of the metal roll is preferably 20°C or higher, more preferably 50°C or higher from the viewpoint of the adhesive property. If the surface temperature of the metal roll is lower than 20°C, the interlaminar adhesive force may be unfavorably insufficient after the lamination. In other words, it is preferred that the metal roll is heated when used. It is however feared that the film contacting the heated metal roll is thermally shrunken to be lowered in performance (particularly, water vapor permeability). Thus, the film which is to contact the metal roll is preferably a weather-resistant film that is not easily lowered in performance when thermally shrunken.

In the meantime, the surface temperature of the flexible roll is preferably 150°C or lower, more preferably 130°C or lower. If the surface temperature of the flexible roll is higher than 150°C, the film contacting the flexible roll may be largely thermally shrunken to be lowered in performance (particularly, water vapor permeability). It is therefore preferred that the film which is to contact the flexible roll is the third layer.

In a case where the first or third layer is a vapor-deposit-attached polyester resin film, its vapor-deposited layer may be cracked if the vapor-deposit-attached polyester resin film is thermally shrunken at the time of the lamination. Thus, the film may be lowered in water-vapor-barrier performance. Accordingly, the shrinkage ratio in the width direction of the film is restrained preferably into 5% or less, more preferably into 3% or less.

When the laminating rolls are rotated to feed the individual films, it is preferred to apply, to each of the films to be fed out, a tension along the feeding-out direction, thereby controlling the shrinkage ratio of the film. The tension is preferably 0.01 to 100 N/m, more preferably 0.1 to 50 N/m.

In a case where the first or third layer is a vapor-deposit-attached polyester resin film, the following is desired when the lamination is conducted to bring the vapor-deposited layer of this film into contact with the laminating roll or a carrying roll: the film is handled not to cause a matter that the vapor-deposited layer is scratched by friction between this layer and the laminating rolls or the other so that the film is lowered in water-vapor-barrier performance.

When the resin-comprising material is extruded out from the T-die, the temperature of the material is preferably 150 to 300°C, more preferably 170 to 280°C. If the temperature is lower than 150°C, the material is high in melt viscosity so that the formed second layer may become uneven in thickness, or after the lamination the interlaminar adhesive force may be insufficient. If the temperature is higher than 300°C, the material is too low in melt viscosity to be easily shaped.

The laminating pressure between the metal roll and the flexible roll is not particularly limited, and may be appropriately adjusted to give a sufficient interlaminar adhesive force.

The three-layered structure sheet formed as described above can be used as a solar battery back sheet of the invention. Subsequently, substantially the same extrusion lamination may be again performed to laminate a fourth layer and a fifth layer, whereby a solar battery back sheet of the invention which has a five-layered structure can be produced. In this case, it is advisable to perform the second extrusion lamination by extruding the resin-comprising material constituting the fourth layer into a gap between the fifth layer and the three-layered structure sheet formed by the first extrusion lamination. These two extrusion laminations may be continuously performed. Conditions for performing the second extrusion lamination are equivalent to the conditions for performing the first extrusion lamination.

The above-mentioned order for the production may be reverse. In other words, after the production of a three-layered structure sheet composed of the third to fifth layers, the first and second layers may be laminated thereon to produce a solar battery back sheet of the invention which has a five-layered structure.

Instead of the fifth layer, a release sheet to be used only at the time of the lamination may be used. In this case, the release sheet is peeled off from the resultant five-layered structure sheet, whereby a four-layered structure back sheet can be yielded.

### (Producing Method, Method B)

The following will describe a method for producing a solar battery back sheet of the invention without using any shaped film as its third layer while the third layer is formed by extrusion (hereinafter, this method will be referred to as the method B).

In the method B, the solar battery back sheet is formed by three-layer-co-extrusion lamination of extruding each of a resin-comprising material constituting the second layer, a resin-comprising material constituting the third layer, and a resin-comprising material constituting the fourth layer on a surface of the film-form first layer.

First, the resin-comprising material constituting the second layer, the resin-comprising material constituting the third layer, and the resin-comprising material constituting the fourth layer are supplied to respective extruders to be heated and melted.

Before the supply of these resin-comprising materials into the respective extruders, it is preferred to dry each of the resin-comprising materials preliminarily in advance. The preliminary drying makes it possible to prevent the materials extruded out from the respective extruders from being foamed. The method for the preliminary drying is not particularly limited. The drying may be attained by use of, for example, a hot wind drying machine in the state of making each of the resin-comprising materials into the form of pellets or some other.

Next, the resin-comprising materials heated and melted in the respective extruders are supplied to a co-extrusion T-die just before which a feed block is set up, or a co-extrusion T-die of a multi-manifold type. At this time, the use of a gear pump makes it possible to improve the evenness of the extruded quantity of each of the materials to decrease an unevenness in the thickness of the layer to be formed.

When the co-extrusion of the feed block type is performed, it is preferred to make the respective melt viscosities of the three resin-comprising materials heated and melted consistent with each other by effect of the set temperatures of the extruders or some other factor, so as not to give a sheet wherein the second or fourth layer is partially absent.

When the proportion by thickness of the third layer to the other layers is larger than that of the layer in a case where the ratio by thickness of the second layer/the third layer/the fourth layer is 1/10/1, it is preferred to use the multi-manifold type co-extrusion T-die since the film thicknesses of the second and fourth layers can be controlled into an even state.

Next, the individual resin-comprising materials supplied to the co-extrusion T-die are extruded as a sheet-form melted resin from the co-extrusion T-die (three-layer co-extrusion), and then two laminating rolls are used to laminate, onto the first layer, the three-layered structure sheet-form melted resin composed of the second to fourth layers. Thus, the four layers are laminated onto each other. At this time, the sheet-form melted resin is arranged to bring the second layer into contact with the first layer. In this way, a four-layered structure sheet is yielded wherein the first to fourth layers are laminated onto each other.

By using a different film besides the first layer at the time of the lamination, a five-layered structure sheet may be yielded. In this case, the three-layered structure sheet-form melted resin is sandwiched between the first layer and the different layer, and the five layers are laminated onto each other. The different film may be the above-mentioned fifth layer, or a release sheet to be used only at the time of the lamination. The release sheet is peeled off after the lamination, thereby yielding a four-layered structure back sheet.

Preferably, one of the two laminating rolls, between which the sheet-form melted resin is sandwiched, is a rigid metal roll having a smooth surface, and the other is a flexible roll having an elastic outer cylinder which has a smooth surface and is elastically deformable. Between the rigid metal roll and the flexible roll having the elastic outer cylinder, the sheet-form melted resin is sandwiched, and the layers are laminated onto each other. In this way, a sheet can be yielded which is good in the adhesive property between its individual layers and in surface external appearance.

The laminating pressure between the metal roll and the flexible roll is not particularly limited, and may be appropriately adjusted to give a sufficient interlaminar adhesive force.

The surface temperature of the metal roll is preferably 30°C or higher to heighten the interlaminar adhesive force after the lamination. In other words, it is preferred that the metal roll is heated when used. It is however feared that the film contacting the heated metal roll is thermally shrunken to be lowered in performance. Thus, the film which is to contact the metal roll is preferably a weather-resistant film that is not easily lowered in performance when thermally shrunken.

In the meantime, the surface temperature of the flexible roll is preferably 100°C or lower in order that it may not occur that the film contacting this roll is largely thermally shrunken to be lowered in performance. It is therefore preferred that the film which is to contact the flexible roll is a weather-resistant film.

In a case where the first layer is a vapor-deposit-attached polyester resin film, its vapor-deposited layer may be cracked if the vapor-deposit-attached polyester resin film is thermally shrunken at the time of the lamination. Thus, the film may be lowered in water-vapor-barrier performance. Accordingly, the shrinkage ratio in the width direction of the film is restrained preferably into 5% or less, more preferably into 3% or less.

When the laminating rolls are rotated to feed the individual films, it is preferred to apply, to each of the films to be fed out, a tension along the feeding-out direction, thereby controlling the shrinkage ratio of the film. The tension is preferably 0.01 to 100 N/m, more preferably 0.1 to 50 N/m.

In a case where the first layer is a vapor-deposit-attached polyester resin film, the following is desired when the lamination is conducted to bring the vapor-deposited layer of this film into contact with the laminating roll or a carrying roll: the film is handled not to cause a matter that the vapor-deposited layer is scratched by friction between the layer and the laminating rolls or the other so that the film is lowered in water-vapor-barrier performance.

The temperature of each of the resin-comprising materials when the material is extruded out from the T-die is preferably 150 to 300°C, more preferably 170 to 280°C. If the temperature is lower than 150°C, the material is high in melt viscosity so that the formed second layer may become uneven in thickness, or after the lamination the interlaminar adhesive force may be insufficient. If the temperature is higher than 300°C, the material is too low in melt viscosity to be easily shaped.

### (Usage)

By combining the solar battery back sheet of the invention with a solar battery element, a solar battery module can be formed. In this case, the first layer is arranged farthest from the solar battery element. When the back sheet is composed of the first to third layers, the layer nearest to the solar battery is the third layer. When the back sheet is composed of the first to fourth layers, the nearest layer is the fourth layer. When the back sheet is composed of the first to fifth layers, the nearest layer is the fifth layer.

When the layer nearest to the solar battery is the third or fifth layer, a solar battery element sealed with a separately-prepared sealing material (for example, ethylene/vinyl alcohol copolymer) is arranged onto the surface of this outermost layer. On the outer surface of the third or fifth layer, a primer coat layer may be laid to heighten the adhesive property onto the sealing material. The primer coat layer is not particularly limited, and may be a layer made of the same ethylene/vinyl alcohol copolymer as used as the sealing material, or a layer made of the modified polyolefin resin as used in the second or fourth layer.

When the layer nearest to the solar battery is the fourth layer, in the same way as described above, a solar battery element sealed with a separately-prepared sealing material may be arranged onto the surface of the fourth layer. Preferably, the fourth layer and the solar battery element directly contact each other without interposing any different sealing material therebetween so that the fourth layer functions as a sealing material for the solar battery element. In other words, when the back sheet is composed of the first to the fourth layers, the fourth layer which comprises the modified polyolefin resin can also function as a sealing material for the solar battery element. It is therefore unnecessary to arrange a different sealing material between the back sheet and the solar battery element. In this form, the back sheet and the sealing material are formed at a time to be integrated with each other. Thus, the form gives excellent performance for producing a solar battery module.

The solar battery back sheet of the invention can be appropriately used for any solar battery. The back sheet can be appropriately used, particularly, for an amorphous silicon type solar battery, a crystal silicon type solar battery, a hybrid solar battery, or a solar battery of some other type. A location where the solar battery is set is not particularly limited, and examples thereof include a position on a housetop; a position on a roof or wall surface of a building, a factory, a school or a public facility; a position in a seashore; and a position in a desert zone.

Hereinafter, a description will be made about specific embodiments of the solar battery back sheet of the invention.

### (First Embodiment)

A first embodiment of the invention is a five-layered structure solar battery back sheet composed of "a weather-resistant polyester resin film (first layer)/a modified polyolefin resin layer (second layer)/a vapor-deposit-attached polyester resin film (third layer)/a modified polyolefin resin layer (fourth layer)/a weather-resistant polyester resin film (fifth layer)". A solar battery is set on the fifth layer side thereof. This form can certainly keep a high level of water-vapor-barrier performance by the presence of the third layer.

It is preferred that a fluorine-containing paint is further painted onto the outer surface (surface reverse to the second-layer-side surface) of the weather-resistant polyester resin film as the first layer to improve the weather resistance.

It is preferred that a primer coat layer is further laid onto the outer surface (surface reverse to the fourth-layer-side surface) of the weather-resistant polyester resin film as the fifth layer to improve the adhesive property between the outer surface and the sealing material for the solar battery element.

The vapor-deposited layer of the vapor-deposit-attached polyester resin film as the third layer may face onto the second layer, or onto the fourth layer. As described above, however, in order to protect the vapor-deposited layer and restrain curling of the back sheet, it is preferred to arrange the vapor-deposited layer to be opposed to a thicker layer out of the second layer and the fourth layer.

Instead of the vapor-deposit-attached polyester resin film, an aluminum foil piece may be used as the third layer.

It is preferred to incorporate a white pigment into the fifth layer so that the layer can reflect sunlight.

The first embodiment can be favorably produced by the method A.

### (Second Embodiment)

A second embodiment of the invention is a three-layered structure solar battery back sheet composed of "a weather-resistant polyester resin film (first layer)/a modified polyolefin resin layer (second layer)/a weather-resistant polyester resin film (third layer)". A solar battery is set on the third layer side thereof.

It is preferred that a fluorine-containing paint is further painted onto the outer surface (surface reverse to the second-layer-side surface) of the weather-resistant polyester resin film as the first layer to improve the weather resistance.

It is preferred that a primer coat layer is further laid onto the outer surface (surface reverse to the second-layer-side surface) of the weather-resistant polyester resin film as the third layer to improve the adhesive property between the outer surface and the sealing material for the solar battery element.

It is preferred to incorporate a white pigment into the third layer so that the layer can reflect sunlight.

In this embodiment, it is preferred that the second layer is larger in thickness than the third layer. This is for the purpose that the whole of the solar battery back sheet can certainly keep a thickness appropriate for attaining voltage resistance required for the back sheet. Specifically, the thickness of the second layer is preferably 100 µm or more, more preferably 150 µm or more. Since the second layer is thick as described herein, the solar battery back sheet can attain water-vapor-barrier performance required therefor.

The second embodiment can be favorably produced by the method A.

### (Third Embodiment)

A third embodiment of the invention is a four-layered structure solar battery back sheet composed of "a weather-resistant polyester resin film (first layer)/a modified polyolefin resin layer (second layer)/a resin layer the resin component of which is made of an unmodified polyolefin resin (third layer)/a modified polyolefin resin layer (fourth layer)". This form can certainly keep water-vapor-barrier performance necessary for the solar battery back sheet since the second, third and fourth layers are made of olefin resins, respectively.

A solar battery element is arranged to contact the surface of the fourth layer directly. In this case, it is unnecessary to arrange a sealing material for sealing the solar battery element between the solar battery element and the fourth layer. The fourth layer functions as a sealing material for the solar battery element. In other words, the solar battery back sheet in this form is not a mere back sheet but a back sheet also having a function as a sealing material for the solar battery element.

A fluorine-containing paint may be further painted onto the outer surface (surface reverse to the second-layer-side surface) of the weather-resistant polyester resin film as the first layer to improve the weather resistance.

The third embodiment can be favorably produced by the method B.

The third embodiment is in particular preferably in the following form:
First layer: a weather-resistant film;
Second layer: a layer which is made of a modified polyolefin resin yielded by grafting 1 to 30 parts by weight of an epoxy-group-containing vinyl monomer and 3 to 5 parts by weight of an aromatic vinyl monomer to 100 parts by weight of a polyolefin resin, and which has a thickness of 5 to 100 µm;
Third layer: a layer made of an unmodified polyolefin and having a thickness of 90 to 600 µm; and
Fourth layer: a layer which is made of a modified polyolefin resin yielded by grafting 1 to 30 parts by weight of an epoxy-group-containing vinyl monomer and 0 to 5 parts by weight of an aromatic vinyl monomer to 100 parts by weight of a polyolefin resin, and which has a thickness of 5 to 100 µm.

As the use amount of the aromatic vinyl monomer is smaller in the fourth layer in the present embodiment, the adhesive force thereof to a solar battery element or glass is higher; thus, the invasion of water into the solar battery module from an end face thereof can be prevented. As a result, the solar battery module is favorably improved in heat and humidity resistance. From this viewpoint, in the fourth layer in the third embodiment, the use amount of the aromatic vinyl monomer is preferably 0 to 1 part by weight, more preferably 0 part by weight.

### EXAMPLES

Hereinafter, the invention will be described in more detail by way of working examples; however, the invention is not limited by these examples.

### (Examples 1 to 9 and Comparative Example 1)

Evaluating methods in Examples 1 to 9 and Comparative Example 1 will be described hereinafter.

### [Evaluation of Adhesive Strength between Films]

A laminated film was cut into a length of 25 mm along the width direction and a length of 200 mm along the longitudinal direction. At one of the two ends thereof, its layers were partially peeled off by about 20 mm by hand to give a margin which is to be sandwiched. Next, a tensile tester (Autograph, AG-2000A, manufactured by Shimadzu Corp.) was used to measure the T-shape peel strength [N/cm] thereof at a test temperature of 23°C and a test speed of 50 mm/min. A determination was made about the superiority or inferiority of the measured adhesive strength in accordance with the following criterion:
○: The respective adhesive strengths between all the films that constitute the laminated film are each 2 N/cm or more.
x: The respective adhesive strengths between all the films that constitute the laminated film are each less than 2 N/cm.

### [External Appearance Observation after Light Radiation]

A laminated film was cut into a size of 15 cm length and 5 cm width, and a xenon weather meter (X75SC, manufactured by Suga Test Instruments Co., Ltd.) was used to radiate light onto the weather-resistant film side of the laminated film in accordance with ASTM G155. After the light radiation, the external appearance was observed, and the superiority or inferiority thereof was determined in accordance with the following criterion:
○: No abnormality is generated.
Δ: It is observed that the film is cracked or discolored.
×: It is observed that the film is remarkably cracked or discolored.

### [Measurement of Strength Retention Rate after Light Radiation]

Light was radiated to a laminated film in the same way as described in item [External Appearance Observation after Light Radiation]. Next, a tensile tester (Autograph, AG-2000A, manufactured by Shimadzu Corp.) was used to measure the tensile strength [MPa] of the laminated film at a test temperature of 23°C and a test speed of 50 mm/min. Also before the light radiation, the tensile strength of the laminated film was measured. After the light radiation, the strength retention rate was then calculated. The superiority or inferiority thereof was determined in accordance with the following criterion:
○: After the light radiation, the strength retention rate is 90% or more.
Δ: After the light radiation, the strength retention rate is 70% or more.
×: After the light radiation, the strength retention rate is less than 70%.

### [Measurement of Water vapor permeability]

A laminated film was cut to have a permeation area of 15.2 cm², and the water vapor permeability thereof was measured in accordance with JIS K 7126-1 (differential pressure method) under a condition that the pressure difference was 75 cmHg at 40°C and 90% RH. The unit thereof is represented by "g/(m²·day)".

### [Evaluation of Thin Film Module Heat and Humidity Resistance]

A commercially available EVA sheet for solar-battery-sealing (Ultra Pearl manufactured by Sanvic Inc.; thickness: 0.40 mm) having a size of 6 inch square was put onto a solar battery amorphous substrate of a size of 5 inch square (product obtained by vapor-depositing silicon and others onto a glass substrate and then working the resultant to form a solar battery element), that is, a thin film solar battery element; and further a laminated film cut out into a size of 6 inch square was then put thereonto so as to position the weather-resistant film thereof onto the outside (onto the upper side). Next, a vacuum laminator (Spi-Laminator, manufactured by Spire Corp.) was used to shape these members at a time to be integrated with each other. In this way, a thin film solar battery module was yielded. Conditions for the shaping for the integration are as follows: the temperature is 170°C, the period for degassing is 3.5 minutes, the pressing pressure is 1 kg/cm², and the pressing period is 3.5 minutes. The resultant solar battery module was further heated in an oven of 150°C for 120 minutes to crosslink the EVA.

A solar simulator, the spectrum of which was adjusted into AM 1.5, was used to radiate pseudo-sunlight onto the produced solar battery module into a radiation intensity of 1000 mW/cm² at 25°C. Measurements were then made about the open voltage [V] of the solar battery, the nominal maximum-power operating-current [A] thereof per cm², and the nominal maximum-power operating-voltage [V] thereof per cm². From the product of these values, the initial value of the nominal maximum power [W] (JIS C8911 1998) was calculated out.

Next, the solar battery module was allowed to stand still in an environment having a temperature of 85°C and a relative humidity of 85% for 1000 hours. In this way, a heat and humidity resistance test was made. After the still standing, about the solar battery module, the nominal maximum power [W] was calculated out in the same way as descried above. The superiority or inferiority of the heat and humidity resistance was then determined in accordance with the following criterion:
○: The value obtained by dividing the nominal maximum power after the 1000-hour heat and humidity resistance test by the initial value is 0.9 or more.
Δ: The value obtained by dividing the nominal maximum power after the 1000-hour heat and humidity resistance test by the initial value is 0.8 or more.
×: The value obtained by dividing the nominal maximum power after the 1000-hour heat and humidity resistance test by the initial value is less than 0.8.

### [Evaluation of Crystal Module Heat and Humidity Resistance]

Onto a glass plate (manufactured by Nippon Sheet Glass Co., Ltd.; thickness: 3.2 mm) having a size of 6 inch square were put a commercially available EVA sheet for solar-battery-sealing (Ultra Pearl manufactured by Sanvic Inc.; thickness: 0.40 mm) having the same size, a crystal Si solar battery element having a size of 5 inch square, a commercially available EVA sheet for solar-battery-sealing having a size of 6 inch square, and a laminated film cut into a size of 6 inch square, in this order, so as to position its weather-resistant film onto the outside (onto the upper side). Next, a vacuum laminator (Spi-Laminator, manufactured by Spire Corp.) was used to shape these members at a time to be integrated with each other. In this way, a crystal silicon solar battery module was yielded. Conditions for the shaping for the integration are as follows: the temperature is 170°C, the period for degassing is 3.5 minutes, the pressing pressure is 1 kg/cm², and the pressing period is 3.5 minutes. The resultant solar battery module was further heated in an oven of 150°C for 120 minutes to crosslink the EVA.

A solar simulator, the spectrum of which was adjusted into AM 1.5, was used to radiate pseudo-sunlight onto the produced solar battery module into a radiation intensity of 1000 mW/cm² at 25°C. Measurements were then made about the open voltage [V] of the solar battery, the nominal maximum-power operating-current [A] thereof per cm², and the nominal maximum-power operating-voltage [V] thereof per cm². From the product of these values, the initial value of the nominal maximum power [W] (JIS C8911 1998) was calculated out.

Next, the solar battery module was allowed to stand still in an environment having a temperature of 85°C and a relative humidity of 85% for 1000 hours. In this way, a heat and humidity resistance test was made. After the still standing, about the solar battery module, the nominal maximum power [W] was calculated out in the same way as described above. The superiority or inferiority of the heat and humidity resistance was determined in accordance with the following criterion:
○: The value obtained by dividing the nominal maximum power after the 1000-hour heat and humidity resistance test by the initial value is 0.9 or more.
Δ: The value obtained by dividing the nominal maximum power after the 1000-hour heat and humidity resistance test by the initial value is 0.8 or more.
×: The value obtained by dividing the nominal maximum power after the 1000-hour heat and humidity resistance test by the initial value is less than 0.8.

### (Preparation Example 1)

The following were preliminarily mixed with each other while stirred: 15 parts by weight of a curable TFE-based copolymer (ZEFFLE GK570, manufactured by Daikin Industries, Ltd.); 35 parts by weight of a white pigment (commercially available titanium oxide; and 15 parts by weight of butyl acetate. Thereto were added 50 parts by weight of glass beads. A pigment disperser was used to disperse the pigment at 1000 rpm for 3 hours. Thereafter, the glass beads were filtrated off through a mesh. To the resultant solution were added 30 parts by weight of a curable TFE-based copolymer (ZEFFLE GK570) and 10 parts by weight of butyl acetate to prepare a fluorine-containing paint 1.

To 100 parts by weight of the resultant "fluorine-containing paint 1" was added 15 parts by weight of a curing agent (commercially available isocyanate-based curing agent) to prepare a fluorine-containing paint 2.

### (Production Example 1) Method for producing a graft-modified polyolefin resin

Into a screw-coupling, co-directionally rotary type biaxial extruder (TEX 44 manufactured by the Japan Steel Works. Ltd.; L/D = 38) with a vent, the temperature of its cylinder being set to 200°C, were supplied 100 parts by weight of a propylene/ethylene copolymer (Versify 3401, manufactured by the Dow Chemical Co.; MFR: 8) and 0.5 parts by weight of 1,3-di(t-butylperoxyisopropyl)benzene (PERBUTYL P, manufactured by NOF Corp.; 1-minute half value period: 175°C). These components were melted and kneaded, and next thereto were added 5 parts by weight of glycidyl methacrylate (BLEMMER G, manufactured by NOF Corp.) and 5 parts by weight of styrene (manufactured by Nihon Oxirane Co., Ltd.) from a nozzle at a middle point of the cylinder to yield pellets of a graft-modified polyolefin resin (hereinafter referred to as a modified olefin). After the modification, the MFR was 5.

### (Production Example 2)

Pellets of a styrene-alone modified olefin were yielded in the same way as in Production Example 1 except that glycidyl methacrylate (BLEMMER G, manufactured by NOF Corp.) was not used. After the modification, the MFR was 3.

### (Production Example 3)

Pellets of a glycidyl-methacrylate-alone modified olefin were yielded in the same way as in Production Example 1 except that styrene (manufactured by Nihon Oxirane Co., Ltd.) was not used. After the modification, the MFR was 55.

### (Production Example 4)

The fluorine-containing paint 2 prepared in Preparation Example 1 was painted onto one surface of a transparent weather-resistant PET film (SHINEBEAM K1653, manufactured by Toyobo Co., Ltd.; thickness: 50 µm, transparent) with a gravure coater to give a film thickness of 10 µm after the workpiece was dried. The workpiece was dried at 120°C for 3 minutes to form a fluorine-containing-paint-coated weather-resistant PET film.

### (Example 1)

The modified olefin yielded in Production Example 1 was dried at 60°C for 15 hours, and then extruded at 270°C by use of a monoaxial extruder having a diameter of 110 mm and a T-die having a width of 700 mm to yield a sheet-form melted resin having a thickness of 90 µm. Onto one of the two surfaces of this sheet-form melted resin was laminated a vapor-deposit-attached PET film 1 (film obtained by laying an organic/inorganic hybrid coat layer onto alumina/silica binary vapor-deposited PET, and further applying an especial treatment onto the coat layer; thickness: 12 µm; water vapor permeability (at 40°C and 90% RH): 0.07 g/(m²·day)) to bring its vapor-deposited layer into contact with the melted resin while onto the other surface was laminated a white weather-resistant PET film (SHINEBEAM CA004, manufactured by Toyobo Co., Ltd.; thickness: 50 µm, white), which was an insulating film coated with an EVA easily-bondable layer. The co-lamination was performed while these members were sandwiched between a metal roll heated to 80°C and a silicon rubber-coated roll heated to 40°C, so as to yield a laminated film intermediate (the EVA easily-bondable layer (primer coat)/the white weather-resistant PET film (fifth layer)/the modified olefin layer (fourth layer)/the vapor-deposit-attached PET film (third layer)).

Next, the modified olefin dried in the above-mentioned way was extruded at 270°C by use of a monoaxial extruder having a diameter of 110 mm and a T-die having a width of 700 mm to yield a sheet-form melted resin having a thickness of 90 µm. Onto one of the two surfaces of this sheet-form melted resin was laminated the laminated film intermediate to bring the PET surface of the vapor-deposit-attached PET film into contact with the melted resin while onto the other surface was laminated the fluorine-containing-paint-coated weather-resistant PET film yielded in Production Example 4 (provided that the weather-resistant PET surface thereof was brought into contact with the melted resin). The co-lamination was performed while these members were sandwiched between a metal roll heated to 80°C and a silicon rubber-coated roll heated to 40°C, so as to yield a laminated film (the EVA easily-bondable layer (primer coat)/the white weather-resistant PET film (fifth layer)/the modified olefin layer (fourth layer)/the vapor-deposit-attached PET film (third layer)/the modified olefin layer (second layer)/the weather-resistant PET film (first layer)/the fluorine-containing paint).

About the resultant laminated film, in Table 1 are shown the adhesive strength between the films thereof, the external appearance after the light radiation, the strength retention rate after the light radiation, the water vapor permeability, and the thin film module heat and humidity resistance.

### (Example 2)

A laminated film was yielded in the same way as in Example 1 except that the vapor-deposit-attached PET film 1 was changed to a vapor-deposit-attached PET film 2 (film obtained by laying an organic/inorganic hybrid coat layer onto alumina/silica binary vapor-deposited PET; thickness: 12 µm; water vapor permeability (at 40°C and 90% RH): 0.1 g/(m²·day)).

About the resultant laminated film, in Table 1 are shown the adhesive strength between the films thereof, the external appearance after the light radiation, the strength retention rate after the light radiation, the water vapor permeability, and the thin film module heat and humidity resistance.

### (Example 3)

A laminated film was yielded in the same way as in Example 1 except that: instead of the insulating film coated with the EVA easily-bondable layer, use was made of a white weather-resistant PET film not coated with any EVA easily-bondable layer (weather-resistant PET film, SHINEBEAM CA003, manufactured by Toyobo Co., Ltd.; thickness: 50 µm, white); and a sheet-form melted resin, 5 µm in thickness, yielded by extruding a modified olefin at 270°C by use of a monoaxial extruder having a diameter of 110 mm and a T-die having a width of 700 mm was laminated onto the surface of the white weather-resistant PET film of the laminated film. In this laminated film, the layer made of the modified olefin and laid on the weather-resistant PET film surface corresponded to a primer coat layer.

About the resultant laminated film, in Table 1 are shown the adhesive strength between the films thereof, the external appearance after the light radiation, the strength retention rate after the light radiation, the water vapor permeability, and the thin film module heat and humidity resistance.

### (Example 4)

A laminated film was yielded in the same way as in Example 3 except that the vapor-deposit-attached PET film 1 was changed to the vapor-deposit-attached PET film 2 used in Example 2.

About the resultant laminated film, in Table 1 are shown the adhesive strength between the films thereof, the external appearance after the light radiation, the strength retention rate after the light radiation, the water vapor permeability, and the thin film module heat and humidity resistance.

### (Example 5)

The modified olefin yielded in Production Example 1 was dried at 60°C for 15 hours, and then extruded at 270°C by use of a monoaxial extruder having a diameter of 110 mm and a T-die having a width of 700 mm to yield a sheet-form melted resin having a thickness of 200 µm. Onto one of the two surfaces of this sheet-form melted resin was laminated the fluorine-containing-paint-coated weather-resistant PET film yielded in Production Example 2 to bring its weather-resistant PET surface into contact with the melted resin while onto the other surface was laminated a white weather-resistant PET film (SHINEBEAM CA004, manufactured by Toyobo Co., Ltd.; thickness: 50 µm, white), which was an insulating film coated with an EVA easily-bondable layer. The co-lamination was performed while these members were sandwiched between a metal roll heated to 80°C and a silicon rubber-coated roll heated to 40°C, so as to yield a laminated film (the EVA easily-bondable layer (primer coat)/the white weather-resistant PET film (third layer)/the modified olefin layer (second layer)/the weather-resistant PET film (first layer)/the fluorine-containing paint).

About the resultant laminated film, in Table 1 are shown the adhesive strength between the films thereof, the external appearance after the light radiation, the strength retention rate after the light radiation, the water vapor permeability, and the crystal module heat and humidity resistance.

### (Example 6)

The modified olefin yielded in Production Example 1 was dried at 60°C for 15 hours, and then extruded at 270°C by use of a monoaxial extruder having a diameter of 110 mm and a T-die having a width of 700 mm to yield a sheet-form melted resin having a thickness of 100 µm. Onto one of the two surfaces of this sheet-form melted resin was laminated the fluorine-containing-paint-coated weather-resistant PET film yielded in Production Example 2 to bring its weather-resistant PET surface into contact with the melted resin while onto the other surface was laminated a white weather-resistant PET film not coated with any EVA easily-bondable layer (weather-resistant PET film, SHINEBEAM CA003, manufactured by Toyobo Co., Ltd.; thickness: 50 µm, white). The co-lamination was performed while these members were sandwiched between a metal roll heated to 80°C and a silicon rubber-coated roll heated to 40°C, so as to yield a laminated film intermediate (the white weather-resistant PET film (third layer)/the modified olefin layer (second layer)/the weather-resistant PET film (first layer)/the fluorine-containing paint).

Next, a sheet-form melted resin, 100 µm in thickness, yielded by extruding a modified olefin at 270°C by use of a monoaxial extruder having a diameter of 110 mm and a T-die having a width of 700 mm was laminated onto the white weather-resistant PET film surface of the laminated film intermediate to yield a laminated film (the modified olefin layer (fourth layer)/the white weather-resistant PET film (third layer)/the modified olefin layer (second layer)/the weather-resistant PET film (first layer)/the fluorine-containing paint layer).

About the resultant laminated film, in Table 1 are shown the adhesive strength between the films thereof, the external appearance after the light radiation, the strength retention rate after the light radiation, the water vapor permeability, and the crystal module heat and humidity resistance.

### (Example 7)

A laminated film was yielded in the same way as in Example 1 except that instead of the vapor-deposit-attached PET film, an aluminum foil piece (manufactured by Toyo Aluminum K.K.; thickness: 30 µm) was used.

About the resultant laminated film, in Table 1 are shown the adhesive strength between the films thereof, the external appearance after the light radiation, the strength retention rate after the light radiation, the water vapor permeability, and the thin film module heat and humidity resistance.

### (Example 8)

A laminated film was yielded in the same way as in Example 1 except that instead of the fluorine-containing-paint-coated weather-resistant PET film, use was made of a white weather-resistant PET film (weather-resistant PET film, SHINEBEAM CA003, manufactured by Toyobo Co., Ltd.; thickness: 50 µm, white).

About the resultant laminated film, in Table 1 are shown the adhesive strength between the films thereof, the external appearance after the light radiation, the strength retention rate after the light radiation, the water vapor permeability, and the thin film module heat and humidity resistance.

### (Example 9)

A laminated film was yielded in the same way as in Example 5 except that instead of the fluorine-containing-paint-coated weather-resistant PET film, use was made of a white weather-resistant PET film (weather-resistant PET film, SHINEBEAM CA003, manufactured by Toyobo Co., Ltd.; thickness: 50 µm, white).

About the resultant laminated film, in Table 1 are shown the adhesive strength between the films thereof, the external appearance after the light radiation, the strength retention rate after the light radiation, the water vapor permeability, and the crystal module heat and humidity resistance.

### (Comparative Example 1)

A laminated film was yielded in the same way as in Example 1 except that instead of the fluorine-containing-paint-coated weather-resistant PET film, use was made of a white non-weather-resistant PET film (PET film, Crisper K1212, manufactured by Toyobo Co., Ltd.; thickness: 50 µm, white).

About the resultant laminated film, in Table 1 are shown the adhesive strength between the films thereof, the external appearance after the light radiation, the strength retention rate after the light radiation, the water vapor permeability, and the thin film module heat and humidity resistance.

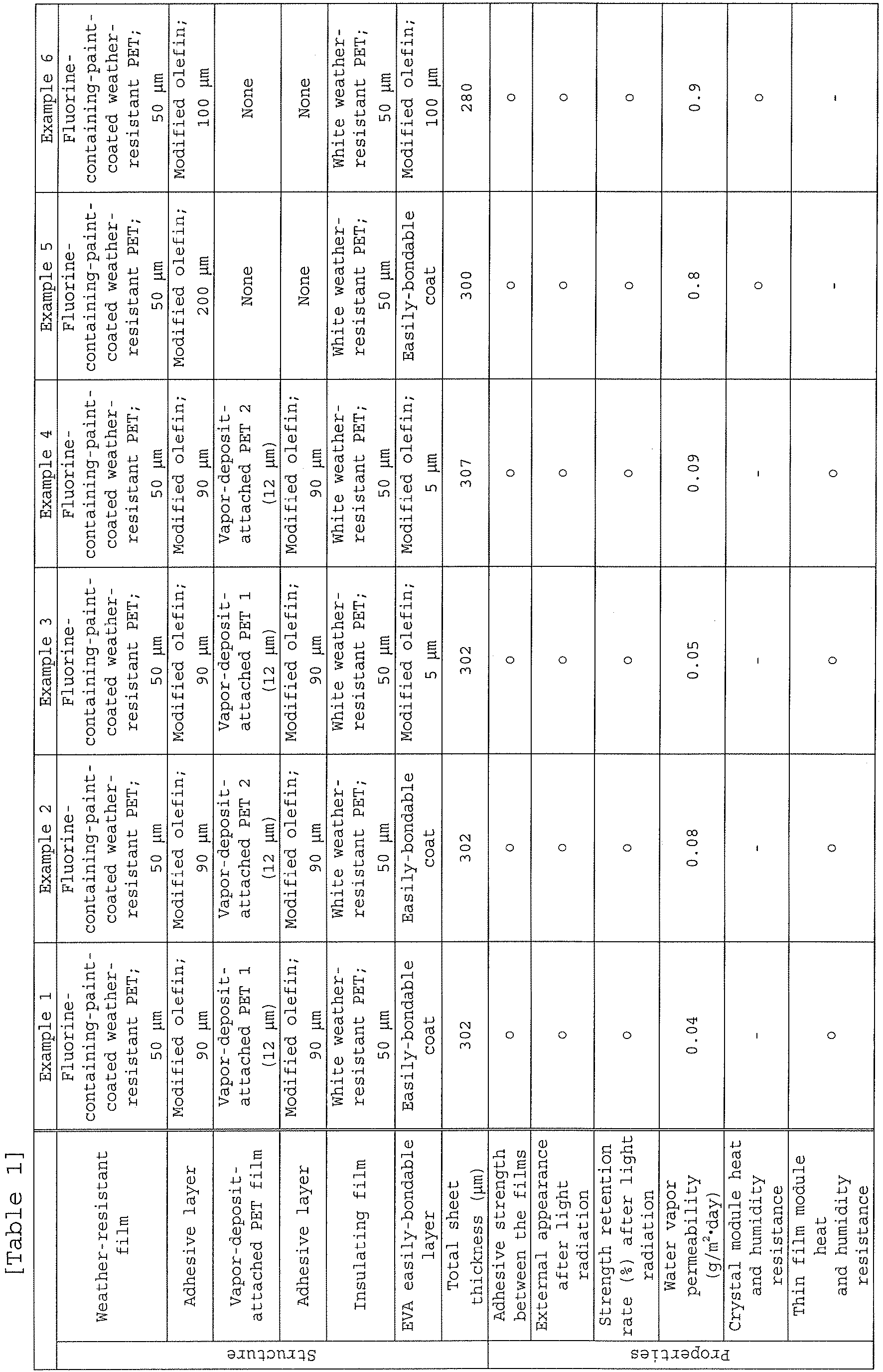

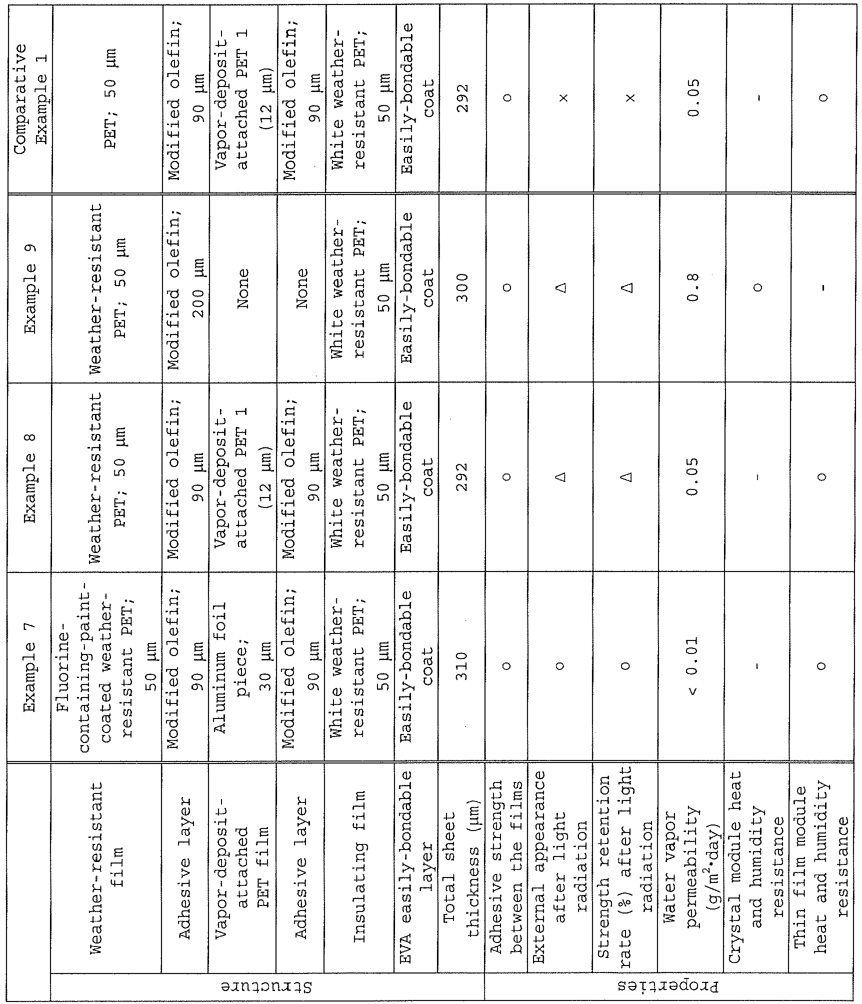

In each of Examples 1 to 9, the weather-resistant film was used as the first layer. Thus, these examples were better in external appearance after the light radiation and strength retention rate after the light radiation than Comparative Example 1 wherein no weather-resistant film was used.

### (Examples 11 to 16 and Comparative Examples 11 to 14)

Evaluating methods in Examples 11 to 16 and Comparative Examples 11 to 14 will be described hereinafter.

### [Evaluation of Adhesive Strength between Films]

A laminated film is determined about the superiority or inferiority of the adhesive strength therein in the same way as described above.

### [EVA Adhesive Strength Measurement]

Onto a glass plate (manufactured by Nippon Sheet Glass Co., Ltd.; thickness: 3.2 mm) having a size of 15 cm length and 5 cm width was put a commercially available EVA sheet for solar-battery-sealing (Ultra Pearl manufactured by Sanvic Inc.; thickness: 0.40 mm) having the same size as the glass. A releasing paper piece having a size of 3 cm length and 5 cm width was put onto an end thereof, and further a laminated film cut into the same size as the glass was put thereonto to position its weather-resistant film onto the outside (onto the upper side). Next, a vacuum laminator (Spi-Laminator, manufactured by Spire Corp.) was used to shape these members at a time to be integrated with each other. In the shaping for the integration, the individual members were heated and pressed onto each other under conditions that the temperature is 135°C, the period for degassing is 3.5 minutes, the pressing pressure is 1 kg/cm², and the pressing period is 3.5 minutes. The resultant solar battery module was further heated in an oven of 150°C for 120 minutes to crosslink the EVA. The releasing paper piece sandwiched at the end of the resultant shaped product was removed out to give a margin which is to be sandwiched.

Next, a tensile tester (Autograph, AG-2000A, manufactured by Shimadzu Corp.) was used to measure the 180° peel strength [N/cm] thereof at a test temperature of 23°C and a test speed of 50 mm/min. A determination was made about the superiority or inferiority of the adhesive strength between the EVA sheet and the laminated film in accordance with the following criterion:
○: The adhesive strength is 50 N/cm or more.
×: The adhesive strength is less than 50 N/cm.

### [Measurement of Water vapor permeability]

A laminated film was measured about the water vapor permeability in the same way as described above.

### [Evaluation of Thin Film Module Heat and Humidity Resistance]

A laminated film was measured about the thin film module heat and humidity resistance in the same way as described above.

### (Example 11)

The modified olefin yielded in Production Example 1 was dried at 60°C for 15 hours, and then extruded at 270°C by use of a monoaxial extruder having a diameter of 110 mm and a T-die having a width of 700 mm to yield a sheet-form melted resin having a thickness of 90 µm. Onto one of the two surfaces of this sheet-form melted resin was laminated a vapor-deposit-attached PET film 1 (film obtained by laying an organic/inorganic hybrid coat layer onto alumina/silica binary vapor-deposited PET, and further applying an especial treatment onto the coat layer; thickness: 12 µm; water vapor permeability (at 40°C and 90% RH): 0.07 g/(m²·day)) to bring its vapor-deposited layer into contact with the melted resin while onto the other surface was laminated a white weather-resistant PET film (SHINEBEAM CA004, manufactured by Toyobo Co., Ltd.; thickness: 50 µm, white), which was an insulating film coated with an EVA easily-bondable layer. The co-lamination was performed while these members were sandwiched between a metal roll heated to 80°C and a silicon rubber-coated roll heated to 40°C, so as to yield a laminated film intermediate (the EVA easily-bondable layer (primer coat)/the white weather-resistant PET film (fifth layer)/the modified olefin layer (fourth layer)/the vapor-deposit-attached PET film (third layer)).

Next, the modified olefin dried in the above-mentioned way was extruded at 270°C by use of a monoaxial extruder having a diameter of 110 mm and a T-die having a width of 700 mm to yield a sheet-form melted resin having a thickness of 90 µm. Onto one of the two surfaces of this sheet-form melted resin was laminated the laminated film intermediate to bring the PET surface of the vapor-deposit-attached PET film into contact with the melted resin while onto the other surface was laminated a transparent weather-resistant PET film (SHINEBEAM K1653, manufactured by Toyobo Co., Ltd.; thickness: 50 µm, transparent). The co-lamination was performed while these members were sandwiched between a metal roll heated to 80°C and a silicon rubber-coated roll heated to 40°C, so as to yield a laminated film (the EVA easily-bondable layer (primer coat)/the white weather-resistant PET film (fifth layer)/the modified olefin layer (fourth layer)/the vapor-deposit-attached PET film (third layer)/the modified olefin layer (second layer)/the transparent weather-resistant PET film (first layer)).

About the resultant laminated film, in Table 2 are shown the adhesive strength between the films thereof, the EVA adhesive strength, the water vapor permeability, and the thin film module heat and humidity resistance.

### (Example 12)

A laminated film was yielded in the same way as in Example 11 except that the vapor-deposit-attached PET film 1 was changed to a vapor-deposit-attached PET film 2 (film obtained by laying an organic/inorganic hybrid coat layer onto alumina/silica binary vapor-deposited PET; thickness: 12 µm; water vapor permeability (at 40°C and 90% RH): 0.1 g/(m²·day)).

About the resultant laminated film, in Table 2 are shown the adhesive strength between the films thereof, the EVA adhesive strength, the water vapor permeability, and the thin film module heat and humidity resistance.

### (Example 13)

A laminated film was yielded in the same way as in Example 11 except that the transparent weather-resistant PET film was changed to a PVDF (polyvinylidene fluoride) film (KYNAR FILM (trade name), manufactured by Arkema Inc.; thickness: 30 µm).

About the resultant laminated film, in Table 2 are shown the adhesive strength between the films thereof, the EVA adhesive strength, the water vapor permeability, and the thin film module heat and humidity resistance.

### (Example 14)

A laminated film was yielded in the same way as in Example 11 except that the vapor-deposit-attached PET film 1 was changed to the vapor-deposit-attached PET film 2, and the transparent weather-resistant PET film was changed to the PVDF film.

About the resultant laminated film, in Table 2 are shown the adhesive strength between the films thereof, the EVA adhesive strength, the water vapor permeability, and the thin film module heat and humidity resistance.

### (Example 15)

A laminated film was yielded in the same way as in Example 11 except that: instead of the insulating film coated with the EVA easily-bondable layer, use was made of a white weather-resistant PET film not coated with any EVA easily-bondable layer (weather-resistant PET film, SHINEBEAM CA003, manufactured by Toyobo Co., Ltd.; thickness: 50 µm, white); and a sheet-form melted resin, 5 µm in thickness, yielded by extruding a modified olefin at 270°C by use of a monoaxial extruder having a diameter of 110 mm and a T-die having a width of 700 mm was laminated onto the surface of the white weather-resistant PET film of the laminated film. In this laminated film, the layer made of the modified olefin and laid on the weather-resistant PET film surface corresponded to a primer coat layer.

About the resultant laminated film, in Table 2 are shown the adhesive strength between the films thereof, the EVA adhesive strength, the water vapor permeability, and the thin film module heat and humidity resistance.

### (Example 16)

A laminated film was yielded in the same way as in Example 15 except that the vapor-deposit-attached PET film 1 was changed to the vapor-deposit-attached PET film 2.

About the resultant laminated film, in Table 2 are shown the adhesive strength between the films thereof, the EVA adhesive strength, the water vapor permeability, and the thin film module heat and humidity resistance.

### (Comparative Example 11)

A laminated film was yielded in the same way as in Example 15 except that instead of the modified olefins constituting the second and fourth layers, respectively, a polyethylene (low-density polyethylene, MIRASON, manufactured by Du Pont-Mitsui Polychemicals Co., Ltd.; MRF = 4.8) was used.

About the resultant laminated film, in Table 2 are shown the adhesive strength between the films thereof, the EVA adhesive strength, the water vapor permeability, and the thin film module heat and humidity resistance.

### (Comparative Example 12)

A laminated film was yielded in the same way as in Example 11 except that instead of the modified olefins constituting the second and fourth layers, respectively, the styrene-alone modified olefin yielded in Production Example 2 was used.

About the resultant laminated film, in Table 2 are shown the adhesive strength between the films thereof, the EVA adhesive strength, the water vapor permeability, and the thin film module heat and humidity resistance.

### (Comparative Example 13)

A laminated film was yielded in the same way as in Example 11 except that instead of the modified olefins constituting the second and fourth layers, respectively, the glycidyl-methacrylate-alone modified olefin yielded in Production Example 3 was used.

About the resultant laminated film, in Table 2 are shown the adhesive strength between the films thereof, the EVA adhesive strength, the water vapor permeability, and the thin film module heat and humidity resistance.

### (Comparative Example 14)

A laminated film was yielded in the same way as in Example 11 except that instead of the modified olefins constituting the second and fourth layers, respectively, a propylene/ethylene copolymer (Versify 3401, manufactured by the Dow Chemical Co.; MRF: 8) was used.

About the resultant laminated film, in Table 2 are shown the adhesive strength between the films thereof, the EVA adhesive strength, the water vapor permeability, and the thin film module heat and humidity resistance.

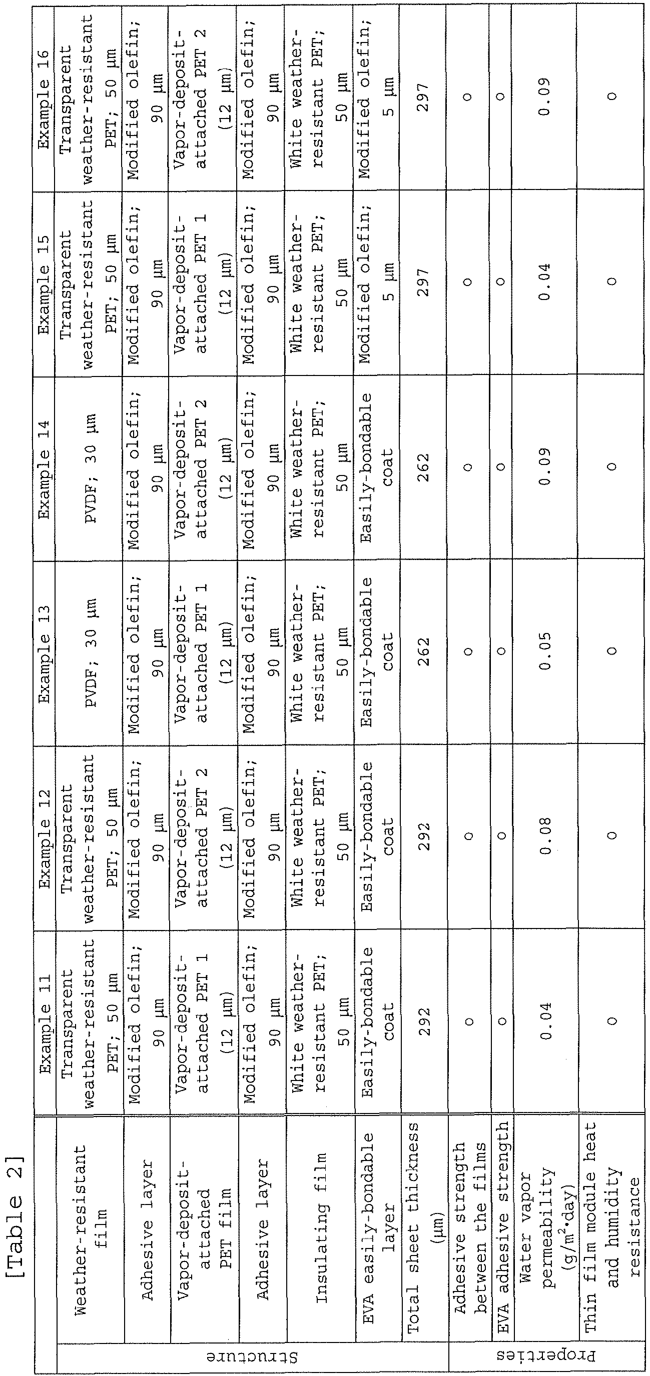

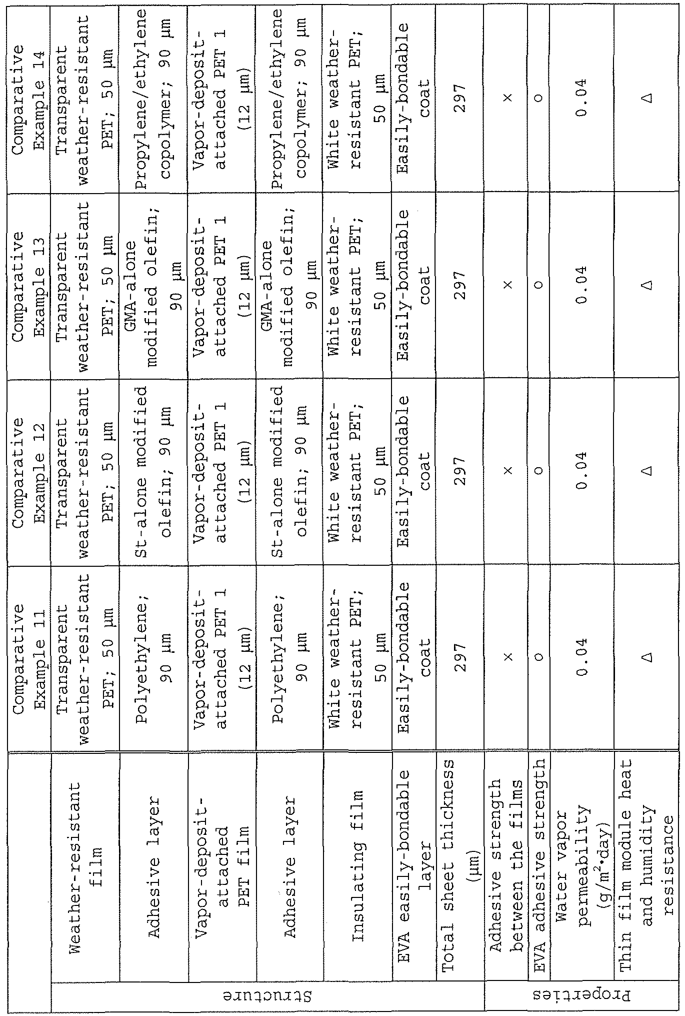

In each of Examples 11 to 16, its second and fourth layers were each the modified polyolefin resin yielded by grafting the specified monomer. Thus, these examples were better in the interlaminar adhesive property than Comparative Examples 11 to 14 wherein such a modified polyolefin resin was neither used in the second nor fourth layer.

### (Examples 21 to 26)

Evaluating methods in Examples 21 to 26 will be described hereinafter.

### [Evaluation of Adhesive Strength between Films]

In the same way as described above, a laminated film was measured about T-shape peel strengths [N/cm] as the adhesive strengths thereof. The peel strength yielded when the peeling was attained from the vapor-deposit-attached PET surface of the laminated film is defined as the "vapor-deposit-attached PET surface" adhesive strength; and that yielded when the peeling was attained from the weather-resistant film surface thereof is defined as the "weather-resistant film surface" adhesive strength. A determination was made about the superiority or inferiority of each of the measured adhesive strengths in accordance with the following criterion:
○: The adhesive strength between the films is 2 N/cm or more.
×: The adhesive strength between the films is less than 2 N/cm.

### [Measurement of Water vapor permeability]

A laminated film was measured about the water vapor permeability in the same way as described above.

### [Measurement of Vapor-deposit-attached PET Film Shrinkage Ratio]

The vapor-deposit-attached PET film laminated was measured about the length in the width direction. This was compared with the beforehand-measured length thereof in the width direction before the lamination. The shrinkage ratio was then calculated out.

### (Example 21)

The modified olefin yielded in Production Example 1 was dried at 60°C for 15 hours, and then extruded at 200°C by use of a monoaxial extruder having a diameter of 40 mm and a T-die having a width of 400 mm to yield a sheet-form melted resin having a thickness of 50 µm. Onto one of the two surfaces of this sheet-form melted resin was laminated a vapor-deposit-attached PET film (ECOSYAR VE500, manufactured by Toyobo Co., Ltd.; thickness: 12 µm; water vapor permeability (at 40°C and 90% RH): 0.6 g/(m²·day)) while onto the other surface was laminated a weather-resistant film (weather-resistant PET film, SHINEBEAM, manufactured by Toyobo Co., Ltd.; thickness: 50 µm). The co-lamination was performed while these members were sandwiched between a metal roll heated to 85°C and a silicon rubber-coated roll heated to 35°C, so as to yield a three-layered laminated film (the weather-resistant PET film (first layer)/the modified olefin layer (second layer)/the vapor-deposit-attached PET film (third layer)). In such a manner that the vapor-deposit-attached PET film would be brought into contact with the silicon rubber-coated roll, the co-lamination was performed.

About the resultant laminated film, in Table 3 are shown the respective adhesive strengths between the films, the water vapor permeability, and the shrinkage ratio of the vapor-deposit-attached PET film.

### (Example 22)

A laminated film was yielded in the same way as in Example 21 except that the T-die temperature for extruding the modified olefin was changed to 250°C. About the resultant laminated film, in Table 3 are shown the respective adhesive strengths between the films, the water vapor permeability, and the shrinkage ratio of the vapor-deposit-attached PET film.

### (Example 23)

A laminated film was yielded in the same way as in Example 21 except that the T-die temperature for extruding the modified olefin was changed to 250°C, and the temperature of the metal roll was changed to 100°C. About the resultant laminated film, in Table 3 are shown the respective adhesive strengths between the films, the water vapor permeability, and the shrinkage ratio of the vapor-deposit-attached PET film.

### (Example 24)

A laminated film was yielded in the same way as in Example 21 except that the T-die temperature for extruding the modified olefin was changed to 250°C, and the extrusion was performed in the state that 10 parts by weight of an tackiness supplier (YS POLYSTAR T130, manufactured by Yasuhara Chemical Co., Ltd.) was added thereto. About the resultant laminated film, in Table 3 are shown the respective adhesive strengths between the films, the water vapor permeability, and the shrinkage ratio of the vapor-deposit-attached PET film.

### (Example 25)

A laminated film was yielded in the same way as in Example 21 except that the T-die temperature for extruding the modified olefin was changed to 250°C, and the temperature of the silicon rubber-coated roll was changed to 120°C. About the resultant laminated film, in Table 3 are shown the respective adhesive strengths between the films, the water vapor permeability, and the shrinkage ratio of the vapor-deposit-attached PET film.

### (Example 26)

A laminated film was yielded in the same way as in Example 21 except that the temperature of each of the metal roll and the silicon rubber-coated roll was changed to 20°C. About the resultant laminated film, in Table 3 are shown the respective adhesive strengths between the films, the water vapor permeability, and the shrinkage ratio of the vapor-deposit-attached PET film.

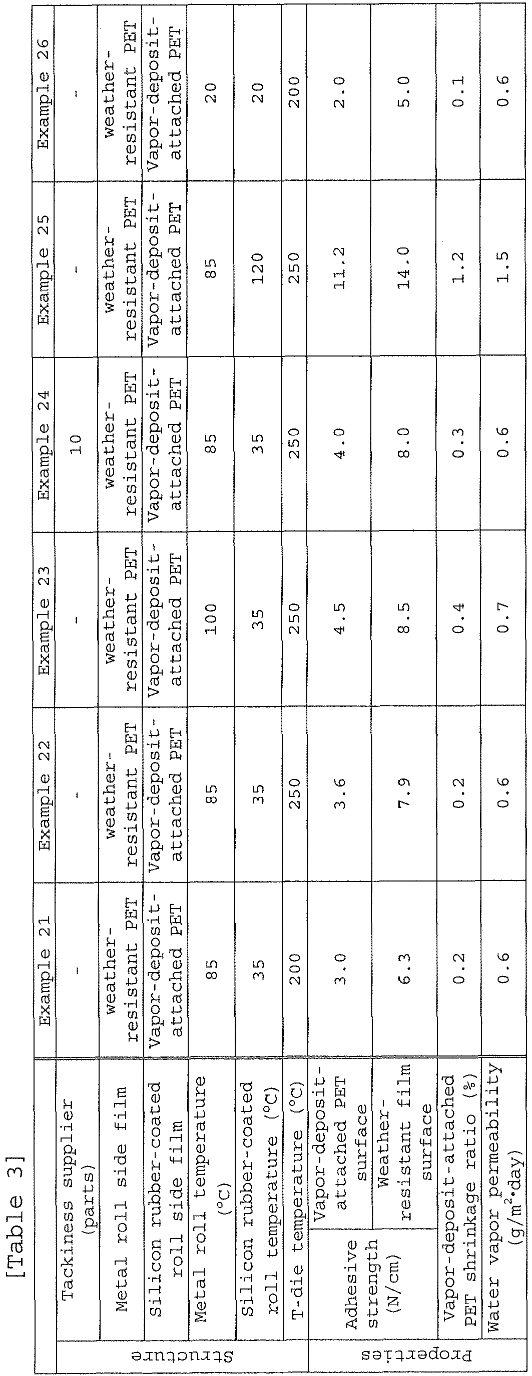

In Examples 21 to 26, the adhesive strength was high, and their vapor-deposit-attached PET was restrained from being thermally shrunken. The water vapor permeability of their vapor-deposit-attached PET film before the lamination was kept.

### (Examples 31 to 38)

Evaluating methods in Examples 31 to 38 will be described hereinafter.

### [Measurement of Adhesive Strength between Weather-Resistant Film and Sheet A]

In the same way as described above, a laminated film is measured about the T-shape peel strength [N/cm] as the adhesive strength thereof.

### [Measurement of Adhesive Strength between Sheets]

A laminated film was cut into a length of 25 mm in the width direction and a length of 100 mm in the longitudinal direction, and at one of the two ends thereof, the sheets were peeled from each other by hand. At this time, a determination was made about the superiority or inferiority of the adhesive strength in accordance with the following criterion:
○: The sheets are not easily peeled by hand, and the sheets are integrated with each other.
×: The sheets can be peeled by hand.

### [Measurement of Adhesive Strength between Sheet C and Crystal Cell]

Onto a glass plate (manufactured by Nippon Sheet Glass Co., Ltd.; thickness: 3.2 mm) having a size of 5 inch square were put a commercially available EVA sheet for solar-battery-sealing (Ultra Pearl manufactured by Sanvic Inc.; thickness: 0.40 mm) having the same size, a crystal Si solar battery element having a size of 5 inch square, and a laminated film cut into a size of 5 inch square, in this order, so as to position its weather-resistant film onto the outside (onto the upper side). Next, a vacuum laminator (Spi-Laminator, manufactured by Spire Corp.) was used to shape these members at a time to be integrated with each other. In this way, a test piece for evaluation was yielded. Conditions for the shaping for the integration are as follows: the temperature is 170°C, the period for degassing is 3.5 minutes, the pressing pressure is 1 kg/cm², and the pressing period is 3.5 minutes. At an end of the laminated film of the resultant test piece, the laminar members in the film were peeled from each other by hand. At this time, a determination was made about the superiority or inferiority of the adhesive strength in accordance with the following criterion:
○: The members are not easily peeled by hand, or the crystal cell is cracked.
Δ: The members can be peeled by hand; however, the peel strength is large.
×: The members can be peeled by hand.

### [Measurement of Water Vapor Permeability]

In the same way as described above, a laminated film was measured about the water vapor permeability.

### [Evaluation of Crystal Module Heat and Humidity Resistance]

Onto a glass plate (manufactured by Nippon Sheet Glass Co., Ltd.; thickness: 3.2 mm) having a size of 5 inch square were put a commercially available EVA sheet for solar-battery-sealing (Ultra Pearl manufactured by Sanvic Inc.; thickness: 0.40 mm) having a size of 6 inch square, and a crystal Si solar battery element in this order. Thereon was further put a laminated film cut into a size of 6 inch square to position its weather-resistant film onto the outside (upper side). Next, a vacuum laminator (Spi-Laminator, manufactured by Spire Corp.) was used to shape these members at a time to be integrated with each other. In this way, a crystal silicon solar battery module was yielded. Conditions for the shaping for the integration are as follows: the temperature is 135°C, the period for degassing is 3.5 minutes, the pressing pressure is 1 kg/cm², and the pressing period is 3.5 minutes. The resultant solar battery module was further heated in an oven of 150°C for 120 minutes to crosslink the EVA.

A solar simulator, the spectrum of which was adjusted into AM 1.5, was used to radiate pseudo-sunlight onto the produced solar battery module into a radiation intensity of 1000 mW/cm² at 25°C. Measurements were then made about the open voltage [V] of the solar battery, the nominal maximum-power operating-current [A] thereof per cm², and the nominal maximum-power operating-voltage [V] thereof per cm². From the product of these values, the initial value of the nominal maximum power [W] (JIS C8911 1998) was calculated out.

Next, the solar battery module was allowed to stand still in an environment having a temperature of 85°C and a relative humidity of 85% for 2000 hours. In this way, a heat and humidity resistance test was made. After the still standing, about the solar battery module, the nominal maximum power [W] was calculated out in the same way as described above. The superiority or inferiority of the heat and humidity resistance was determined. The determination of the superiority or inferiority was made in accordance with the following criterion:
○: The value obtained by dividing the nominal maximum power after the 2000-hour heat and humidity resistance test by the initial value is 0.9 or more.
Δ: The value obtained by dividing the nominal maximum power after the 2000-hour heat and humidity resistance test by the initial value is 0.8 or more.
×: The value obtained by dividing the nominal maximum power after the 2000-hour heat and humidity resistance test by the initial value is less than 0.8.

### (Production Example of Modified Olefin)

A modified olefin yielded by the method described in Production Example 1 is called AR1.

Modified olefins AR2 to AR4 and CR1 to CR4 were each produced in the same way as in Production Example 1 except that the kind of the resin component, the use amount of the polymerization initiator PERBUTYL P, or the use amount of each of the monomers was changed. These olefins were used in working examples that will be described later.

Unmodified polyolefins are called BR1 and BR2, respectively, and used in the working examples, which will be described later.

In Table 4 is shown the composition of each of the modified olefins and the polyolefins.

**[Table 4]**

| | | AR1 | AR2 | AR3 | AR4 | BR1 | BR2 | CR1 | CR2 | CR3 | CR4 |
|---|---|---|---|---|---|---|---|---|---|---|---|
| Base resin | Kind | EPCP | EPCP | EPCP | LDPE | EPCP | LDPE | EPCP | EPCP | EPCP | LDPE |
| | Parts by weight | 100 | 100 | 100 | 100 | 100 | 100 | 100 | 100 | 100 | 100 |
| PERBUTYL P | Parts by weight | 0.5 | 0.5 | 0.5 | 5 | 0 | 0 | 0.5 | 0.5 | 0.5 | 0.5 |
| Styrene | Parts by weight | 5 | 3 | 0.5 | 5 | 0 | 0 | 0 | 0 | 1.5 | 0 |
| GMA | Parts by weight | 5 | 5 | 5 | 5 | 0 | 0 | 2 | 5 | 2 | 5 |

In Table 4, EPCP is an ethylene/propylene copolymer (Versify 3401. 05, manufactured by the Dow Chemical Co.); LDPE, a low-density polyethylene (MIRASON 403P, manufactured by Du Pont-Mitsui Polychemicals Co., Ltd.; MRF = 4.8); PERBUTYL P, 1,3-di(t-butylperoxyisopropyl)benzene (PERBUTYL P, manufactured by NOF Corp.; 1-minute half value period: 175°C), which is a radical polymerization initiator; styrene, a styrene monomer (manufactured by Nihon Oxirane Co., Ltd.); and GMA, glycidyl methacrylate (BLEMMER G, manufactured by NOF Corp.).

### (Production Example 3) Method for Producing Polyolefin Resin Composition BRC

To a biaxial extruder (TEX 44, manufactured by the Japan Steel Works. Ltd.; L/D = 38), the temperature of which was set to 200°C, 100 parts by weight of BR2 in Table 4 and 5 parts by weight of titanium oxide were supplied, and then melted and kneaded to yield pellets of a polyolefin resin composition BRC2.

In the same way, a composition described in Table 5 was used to yield pellets of a polyolefin resin composition BRC3. These pellets were used in the working examples, which will be described later.

Moreover, AR1 to AR4, BR1, and CR1 to CR4 in Table 4 were turned to modified polyolefin resin compositions ARC1 to ARC4, BRC1, and CRC1 to CRC4, respectively. These compositions were used in the working examples, which will be described later.

**[Table 5]**

| | | ARC1 | ARC2 | ARC3 | ARC4 | BRC1 | BRC2 | BRC3 | CRC1 | CRC2 | CRC3 | CRC4 |
|---|---|---|---|---|---|---|---|---|---|---|---|---|
| Resin pellets | Kind | AR1 | AR2 | AR3 | AR4 | BR1 | BR2 | BR1 | CR1 | CR2 | CR3 | CR4 |
| | Parts by weight | 100 | 100 | 100 | 100 | 100 | 100 | 100 | 100 | 100 | 100 | 100 |
| Titanium oxide | Parts by weight | 0 | 0 | 0 | 0 | 0 | 5 | 5 | 0 | 0 | 0 | 0 |

In Table 5, titanium oxide is titanium oxide (IV) (D-918, manufactured by Sakai Chemical Industry Co., Ltd.).

### (Example 31)

Using extruders corresponding to the three resin compositions, i.e., the modified polyolefin resin compositions ARC1 and CRC1 and the polyolefin resin composition BRC1, respective melted resins were supplied to a co-extruding T-die, 400 mm in width, just before which a feed block was set, so as to be extruded into a sheet-form melted resin composed of three layers. A weather-resistant PET film (SHINEBEAM K1653, manufactured by Toyobo Co., Ltd.; thickness: 50 µm) was laminated onto the ARC1 side of this three-layered sheet while this workpiece was sandwiched between a metal roll and a silicon rubber-coated roll. In this way, a laminated film was yielded.

About the resultant laminated film, in Table 6 are shown evaluation results of the adhesive strength between the films, the water vapor permeability, and the crystal module heat and humidity resistance.

### (Examples 32 to 38)

Laminated films were yielded in the same way as in Example 31 except that the kinds of the modified polyolefin resin composition, the polyolefin resin composition and the weather-resistant film were changed. About each of the resultant laminated films, in Table 6 are shown evaluation results of the adhesive strength between the films, the water vapor permeability, and the crystal module heat and humidity resistance.

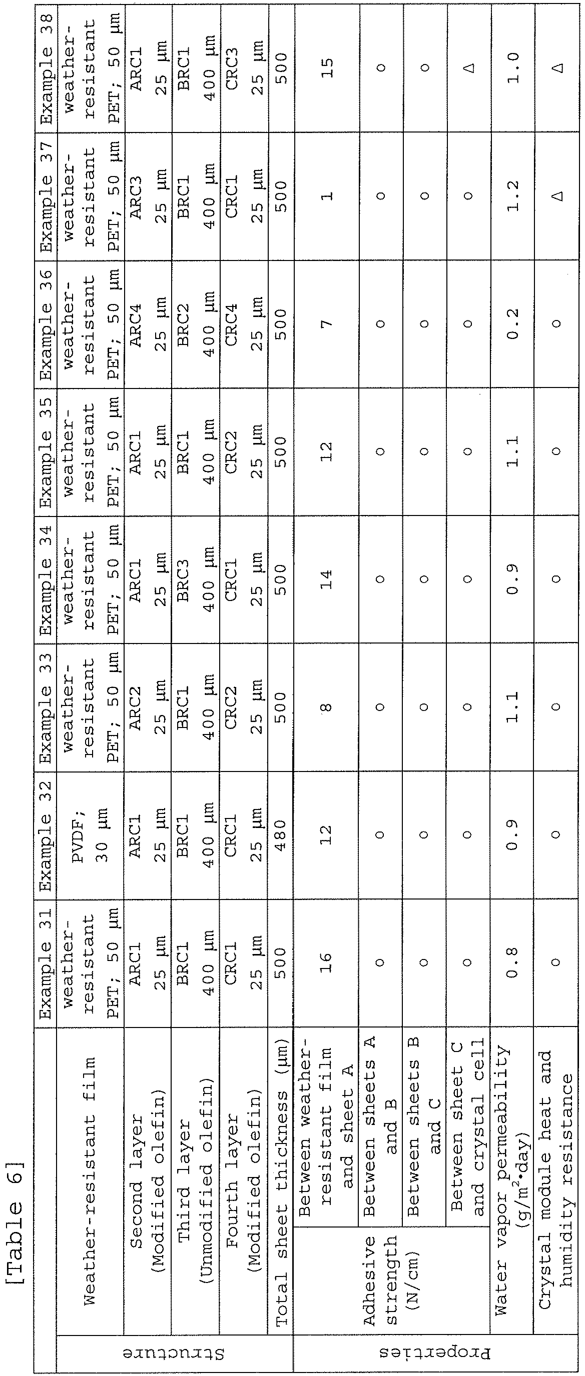

In Table 6, PVDF is a polyvinylidene fluoride film (KYNAR FILM (trade name), manufactured by Arkema Inc.; thickness: 30 µm).

Each of Examples 31 to 38 was excellent in water-vapor-barrier performance, interlaminar adhesive property, and heat and humidity resistance. The solar battery element was arranged directly on the fourth layer, whereby the solar battery element was able to be sealed without interposing any different sealing material between the fourth layer and the solar battery element.

## Claims

1. A back sheet for a solar battery, which comprises a laminate in which a first layer, a second layer and a third layer are laminated in this order, the first layer being arranged farthest from a solar battery element, wherein
the first layer is a weather-resistant film selected from the group consisting of a weather-resistant polyester resin film and a fluororesin film,
the second layer is a polyolefin layer which comprises a modified polyolefin resin yielded by grafting 1 to 30 parts by weight of an epoxy-group-containing vinyl monomer and 0.1 to 30 parts by weight of an aromatic vinyl monomer to 100 parts by weight of one or more polyolefin resins selected from the group consisting of polyethylene, polypropylene and an ethylene/propylene copolymer, and which has a thickness of 5 to 250 µm,
the third layer is selected from the group consisting of a polyester-comprising layer, a polyolefin-comprising layer, and an aluminum foil piece, and
the second layer and the third layer have a total thickness of 20 µm or more.

2. The solar battery back sheet according to claim 1, further comprising a fourth layer laminated on a surface of the third layer that is a surface opposite to the second-layer-laminated surface of the third layer,
the fourth layer being a polyolefin layer which comprises a modified polyolefin resin yielded by grafting 1 to 30 parts by weight of an epoxy-group-containing vinyl monomer to 100 parts by weight of one or more polyolefin resins selected from the group consisting of polyethylene, polypropylene and an ethylene/propylene copolymer, and which has a thickness of 5 to 250 µm, and
the second layer, the third layer and the fourth layer having a total thickness of 100 µm or more.

3. The solar battery back sheet according to claim 2, wherein the second layer and the fourth layer have a total thickness larger than the thickness of the third layer.

4. The solar battery back sheet according to claim 2 or 3, wherein the third layer is a polyester film having, on one surface thereof, a vapor-deposited layer,
the second layer and the fourth layer are different from each other in thickness, and
the vapor-deposited layer is arranged to be opposed to a layer having a larger thickness out of the second layer and the fourth layer.

5. The solar battery back sheet according to any one of claims 2 to 4, wherein the modified polyolefin resin of the fourth layer is a modified polyolefin resin yielded by further grafting 0.1 to 30 parts by weight of an aromatic vinyl monomer to 100 parts by weight of the polyolefin resin.

6. The solar battery back sheet according to any one of claims 2 to 4, further comprising a fifth layer laminated on a surface of the fourth layer that is a surface opposite to the third-layer-laminated surface of the fourth layer,
the fifth layer being a film selected from the group consisting of a polyester resin film and a fluororesin film.

7. The solar battery back sheet according to claim 1, wherein
the third layer is a layer comprising a polyester, and
the second layer is larger in thickness than the third layer.

8. The solar battery back sheet according to any one of claims 1 to 7,
the adhesive strength between the first layer and the second layer, and that between the second layer and the third layer being each 2 N/cm or more, and
the back sheet having a water vapor permeability (measuring conditions: 40°C and 90% RH) of 0.00001 to 3.0 g/(m²·day).

9. The solar battery back sheet according to any one of claims 1 to 8, which is formed by extrusion lamination of extruding a resin-comprising material constituting the second layer into a gap between the first layer and the third layer that is a layer in a film form.

10. The solar battery back sheet according to claim 6, 8 or 9, which is formed by extrusion lamination of extruding a resin-comprising material constituting the fourth layer into a gap between the third layer that is a layer in a film form and the fifth layer.

11. The solar battery back sheet according to claim 2, which is formed by three-layer co-extrusion lamination of extruding each of a resin-comprising material constituting the second layer, a resin-comprising material constituting the third layer, and a resin-comprising material constituting the fourth layer on a surface of the first layer.

12. The solar battery back sheet according to any one of claims 1 to 11, wherein the third layer is a polyester film having, on one surface, a vapor-deposited layer comprising an inorganic material or an inorganic oxide, and a polymeric film layer laminated on the vapor-deposited layer.

13. The solar battery back sheet according to claim 12, wherein the polymeric film layer comprises at least one resin selected from the group consisting of polyvinylidene chloride, polyvinyl alcohol, and an ethylene/vinyl alcohol copolymer.

14. The solar battery back sheet according to any one of claims 1 to 13, wherein the first layer is a film comprising at least one selected from the group consisting of polyethylene terephthalate, polyethylene naphthalate, polyethylene fluoride, and polyethylene difluoride.

15. A solar battery module, comprising a solar battery element, and the solar battery back sheet recited in any one of claims 1 to 14, wherein the first layer is arranged farthest from the solar battery element.

16. A solar battery module, comprising a solar battery element, and the solar battery back sheet recited in claim 2, wherein the fourth layer contacts the solar battery element to seal the solar battery element.

## Patentansprüche

1. Rückplatte für eine Solarbatterie, die ein Laminat umfasst, in dem eine erste Schicht, eine zweite Schicht und eine dritte Schicht in dieser Reihenfolge laminiert sind, wobei die erste Schicht am weitesten von einem Solarbatterieelement angeordnet ist, wobei
die erste Schicht eine wetterbeständige Schicht ist, ausgewählt aus der Gruppe, bestehend aus einem wetterbeständigen Polyesterharzfilm und einem Fluorharzfilm,
die zweite Schicht eine Polyolefinschicht ist, die ein modifiziertes Polyolefinharz umfasst, das erhalten wird durch Pfropfen von 1 bis 30 Gewichtsteilen eines epoxygruppenhaltigen Vinylmonomers und 0,1 bis 30 Gewichtsteilen eines aromatischen Vinylmonomers an 100 Gewichtsteile eines oder mehrerer Polyolefinharze, ausgewählt aus der Gruppe, bestehend aus Polyethylen, Polypropylen und einem Ethylen/Propylen-Copolymer, und das eine Dicke von 5 bis 250 µm aufweist,
die dritte Schicht ausgewählt ist aus der Gruppe, bestehend aus einer Polyester umfassenden Schicht, einer Polyolefin umfassenden Schicht und einem Aluminiumfolienstück, und
die zweite Schicht und die dritte Schicht eine Gesamtdicke von 20 µm oder mehr aufweisen.

2. Solarbatterierückplatte gemäß Anspruch 1, weiterhin umfassend eine vierte Schicht, die auf einer Fläche der dritten Schicht laminiert ist, die eine zu der mit der zweiten Schicht laminierten Fläche der dritten Schicht entgegengesetzte Fläche ist,
wobei die vierte Schicht eine Polyolefinschicht ist, die ein modifiziertes Polyolefinharz umfasst, das erhalten wird durch Pfropfen von 1 bis 30 Gewichtsteilen eines epoxygruppenhaltigen Vinylmonomers an 100 Gewichtsteile eines oder mehrerer Polyolefinharze, ausgewählt aus der Gruppe, bestehend aus Polyethylen, Polypropylen und einem Ethylen/Propylen-Copolymer, und die eine Dicke von 5 bis 250 µm aufweist, und
die zweite Schicht, die dritte Schicht und die vierte Schicht eine Gesamtdicke von 100 µm oder mehr aufweisen.

3. Solarbatterierückplatte gemäß Anspruch 2, wobei die zweite Schicht und die vierte Schicht eine Gesamtdicke aufweisen, die größer als die Dicke der dritten Schicht ist.

4. Solarbatterierückplatte gemäß Anspruch 2 oder 3, wobei die dritte Schicht ein Polyesterfilm ist, der eine dampfbeschichtete Schicht auf einer Fläche davon aufweist,
die zweite Schicht und die vierte Schicht voneinander unterschiedlich in ihrer Dicke sind und
die dampfbeschichtete Schicht entgegengesetzt angeordnet ist zu einer Schicht, die unter der zweiten Schicht und der vierten Schicht eine größere Dicke aufweist.

5. Solarbatterierückplatte gemäß einem der Ansprüche 2 bis 4, wobei das modifizierte Polyolefinharz der vierten Schicht ein modifiziertes Polyolefinharz ist, das erhalten wird durch weiteres Pfropfen von 0,1 bis 30 Gewichtsteilen eines aromatischen Vinylmonomers an 100 Gewichtsteile des Polyolefinharzes.

6. Solarbatterierückplatte gemäß einem der Ansprüche 2 bis 4, weiterhin umfassend eine fünfte Schicht, die auf einer Fläche der vierten Schicht laminiert ist, die eine zu der mit der dritten Schicht laminierten Fläche der vierten Schicht entgegengesetzte Fläche ist,
wobei die fünfte Schicht ein Film ist, der ausgewählt ist aus der Gruppe, bestehend aus einem Polyesterharzfilm und einem Fluorharzfilm.

7. Solarbatterierückplatte gemäß Anspruch 1,
wobei die dritte Schicht eine Schicht ist, die einen Polyester umfasst, und die zweite Schicht eine größere Dicke als die dritte Schicht aufweist.

8. Solarbatterierückplatte gemäß einem der Ansprüche 1 bis 7,
wobei die Haftkraft zwischen der ersten Schicht und der zweiten Schicht und diese zwischen der zweiten und der dritten Schicht jeweils 2 N/cm oder mehr betragen und
die Rückplatte eine Wasserdampfpermeabilität (Messbedingungen: 40°C und 90% RF) von 0,00001 bis 3,0 g/(m²·Tag) aufweist.

9. Solarbatterierückplatte gemäß einem der Ansprüche 1 bis 8, gebildet durch Extrusionslaminierung oder Extrudieren eines harzhaltigen Materials, das die zweite Schicht bildet, in eine Lücke zwischen der ersten Schicht und der dritten Schicht, die eine Schicht in einer Filmform ist.

10. Solarbatterierückplatte gemäß Anspruch 6, 8 oder 9, gebildet durch Extrusionslaminierung durch Extrudieren eines harzhaltigen Materials, das die vierte Schicht bildet, in eine Lücke zwischen der dritten Schicht, die eine Schicht in einer Filmform ist, und der fünften Schicht.

11. Solarbatterierückplatte gemäß Anspruch 2, gebildet durch Dreischicht-Coextrusionslaminierung durch Extrudieren jeweils jedes eines harzhaltigen Materials, das die zweite Schicht bildet, eines harzhaltigen Materials, das die dritte Schicht bildet und eines harzhaltigen Materials, das die vierte Schicht bildet, auf eine Fläche der ersten Schicht.

12. Solarbatterierückplatte gemäß einem der Ansprüche 1 bis 11, wobei die dritte Schicht eine Polyesterschicht ist, die auf einer Fläche eine ein anorganisches Material oder ein anorganisches Oxid umfassende dampfbeschichtete Schicht und eine auf der dampfbeschichteten Schicht laminierte Polymerfilmschicht aufweist.

13. Solarbatterierückplatte gemäß Anspruch 12, wobei die Polymerfilmschicht wenigstens ein Harz umfasst, das ausgewählt ist aus der Gruppe, bestehend aus Polyvinylidenchlorid, Polyvinylalkohol und einem Ethylen/Vinylalkohol-Copolymer

14. Solarbatterierückplatte gemäß einem der Ansprüche 1 bis 13, wobei die erste Schicht ein Film ist, umfassend wenigstens eines, ausgewählt aus der Gruppe, bestehend aus Polyethylenterephthalat, Polyethylennaphthalat, Polyethylenfluorid und Polyethylendifluorid.

15. Solarbatteriemodul, umfassend ein Solarbatterieelement und die Solarbatterierückplatte gemäß einem der Ansprüche 1 bis 14, wobei die erste Schicht am weitesten von dem Solarbatterieelement angeordnet ist.

16. Solarbatteriemodul, umfassend ein Solarbatterieelement und die Solarbatterierückplatte gemäß Anspruch 2, wobei die vierte Schicht mit dem Solarbatterieelement in Kontakt steht, so dass das Solarbatterieelement versiegelt wird.

## Revendications

1. Feuille arrière de batterie solaire, qui comprend un stratifié dans lequel une première couche, une deuxième couche et une troisième couche sont stratifiées dans cet ordre, la première couche étant disposée à la plus grande distance d'un élément de batterie solaire, dans laquelle
la première couche est un film résistant aux intempéries choisi dans le groupe constitué d'un film de résine de polyester et d'un film de résine fluorée résistants aux intempéries,
la deuxième couche est une couche de polyoléfine qui comprend une résine de polyoléfine modifiée obtenue en greffant 1 à 30 parties en poids d'un monomère vinylique contenant un groupe époxy et 0,1 à 30 parties en poids d'un monomère vinylique aromatique à 100 parties en poids d'une ou plusieurs résines de polyoléfine choisies dans le groupe constitué du polyéthylène, du polypropylène et d'un copolymère d'éthylène/propylène, et qui a une épaisseur de 5 à 250 µm,
la troisième couche est choisie dans le groupe constitué d'une couche comprenant un polyester, d'une couche comprenant une polyoléfine et d'une feuille d'aluminium, et
la deuxième couche et la troisième couche ont une épaisseur totale de 20 µm ou plus.

2. Feuille arrière de batterie solaire selon la revendication 1, comprenant en outre une quatrième couche stratifiée sur une surface de la troisième couche qui est une surface opposée à la surface stratifiée sur la deuxième couche de la troisième couche,
la quatrième couche étant une couche de polyoléfine qui comprend une résine de polyoléfine modifiée obtenue en greffant 1 à 30 parties en poids d'un monomère vinylique contenant un groupe époxy à 100 parties en poids d'une ou plusieurs résines de polyoléfine choisies dans le groupe constitué du polyéthylène, du polypropylène et d'un copolymère d'éthylène/propylène, et qui a une épaisseur de 5 à 250 µm, et
la deuxième couche, la troisième couche et la quatrième couche ayant une épaisseur totale de 100 µm ou plus.

3. Feuille arrière de batterie solaire selon la revendication 2, dans laquelle la deuxième couche et la quatrième couche ont une épaisseur totale supérieure à l'épaisseur de la troisième couche.

4. Feuille arrière de batterie solaire selon la revendication 2 ou 3, dans laquelle la troisième couche est un film de polyester ayant, sur une surface de celui-ci, une couche déposée en phase vapeur,
la deuxième couche et la quatrième couche are sont différentes l'une de l'autre en termes d'épaisseur, et
la couche déposée en phase vapeur est disposée de manière à être opposée à une couche ayant une épaisseur plus importante par rapport à la deuxième couche et à la quatrième couche.

5. Feuille arrière de batterie solaire selon l'une quelconque des revendications 2 à 4, dans laquelle la résine de polyoléfine modifiée de la quatrième couche est une résine de polyoléfine modifiée obtenue en greffant en outre 0,1 à 30 parties en poids d'un monomère vinylique aromatique à 100 parties en poids de la résine de polyoléfine.

6. Feuille arrière de batterie solaire selon l'une quelconque des revendications 2 à 4, comprenant en outre une cinquième couche stratifiée sur une surface de la quatrième couche qui est une surface opposée à la surface stratifiée sur la troisième couche de la quatrième couche,
la cinquième couche étant un film choisi dans le groupe constitué d'un film de résine de polyester et d'un film de résine fluorée.

7. Feuille arrière de batterie solaire selon la revendication 1, dans laquelle
la troisième couche est une couche comprenant un polyester, et
la deuxième couche a une épaisseur plus importante que la troisième couche.

8. Feuille arrière de batterie solaire selon l'une quelconque des revendications 1 à 7,
la force adhésive entre la première couche et la deuxième couche, et celle entre la deuxième couche et la troisième couche étant chacune de 2 N/cm ou plus, et
la feuille arrière ayant une perméabilité à la vapeur d'eau (conditions de mesure : 40 °C et HR de 90 %) de 0,00001 à 3,0 g/(m²·jour).

9. Feuille arrière de batterie solaire selon l'une quelconque des revendications 1 à 8, qui est formée par extrusion-laminage consistant à extruder un matériau comprenant une résine constituant la deuxième couche dans un espace entre la première couche et la troisième couche qui est une couche sous forme de film.

10. Feuille arrière de batterie solaire selon la revendication 6, 8 ou 9, qui est formée par extrusion-laminage consistant à extruder un matériau comprenant une résine constituant la quatrième couche dans un espace entre la troisième couche qui est une couche sous forme de film et la cinquième couche.

11. Feuille arrière de batterie solaire selon la revendication 2, qui est formée par co-extrusion-laminage à trois couches consistant à extruder chacun d'un matériau comprenant une résine constituant la deuxième couche, d'un matériau comprenant une résine constituant la troisième couche, et d'un matériau comprenant une résine constituant la quatrième couche sur une surface de la première couche.

12. Feuille arrière de batterie solaire selon l'une quelconque des revendications 1 à 11, dans laquelle la troisième couche est un film de polyester ayant, sur une surface, une couche déposée en phase vapeur comprenant un matériau inorganique ou un oxyde inorganique, et une couche de film polymère stratifiée sur la couche déposée en phase vapeur.

13. Feuille arrière de batterie solaire selon la revendication 12, dans laquelle la couche de polymère comprend au moins une résine choisie dans le groupe constitué du chlorure de polyvinylidène, de l'alcool polyvinylique et d'un copolymère d'éthylène/alcool vinylique.

14. Feuille arrière de batterie solaire selon l'une quelconque des revendications 1 à 13, dans laquelle la première couche est un film comprenant au moins un élément choisi dans le groupe constitué du téréphtalate de polyéthylène, du naphtalate de polyéthylène, du fluorure de polyéthylène et du difluorure de polyéthylène.

15. Module de batterie solaire, comprenant un élément de batterie solaire, et la feuille arrière de batterie solaire selon l'une quelconque des revendications 1 à 14, dans lequel la première couche est disposée à la plus grande distance de l'élément de batterie solaire.

16. Module de batterie solaire, comprenant un élément de batterie solaire, et la feuille arrière de batterie solaire selon la revendication 2, dans lequel la quatrième couche est en contact avec l'élément de batterie solaire pour étanchéifier l'élément de batterie solaire.
